# EUROPEAN PATENT APPLICATION

(11) **EP 4 675 913 A1**
(43) Date of publication of application: **07.01.2026**
(21) Application number: 24763682.2
(22) Date of filing: 19.02.2024
(51) Int. Cl.: H02P 23/14, G06F 30/23, G06F 30/27, H02P 31/00

(54) **ESTIMATION DEVICE, ESTIMATION MODEL CREATION DEVICE, ESTIMATION METHOD, ESTIMATION MODEL CREATION METHOD, AND PROGRAM**

(30) Priority: 02.03.2023 JP 2023032145
(71) Applicant: NIPPON STEEL CORPORATION, Chiyoda-ku Tokyo 100-8071 (JP)
(72) Inventor: HONMA, Rei, Tokyo 100-8071 (JP)
(74) Representative: Vossius & Partner Patentanwälte Rechtsanwälte mbB
(86) International application number: PCT/JP2024/005741
(87) International publication number: WO 2024/181201

(57) **Abstract**

An estimation model creation device (110) acquires a magnetic flux density distribution in a gap (G) between a rotor (210) and a stator (320). The estimation model creation device (110) calculates an estimated value of a motor evaluation index corresponding to the magnetic flux density distribution by using an estimation model created by learning a relationship between the magnetic flux density distribution in the gap (G) and the motor evaluation index.

## Description

### TECHNICAL FIELD

The present invention relates to an estimation device, an estimation model creation device, an estimation method, an estimation model creation method, and a program. This application is based upon and claims the benefit of priority of the prior Japanese Patent Application No. 2023-032145, filed on March 2, 2023, the entire contents of which are incorporated herein by reference.

### BACKGROUND ART

As a method of estimating the characteristics of a rotary electric machine (a motor and a generator), Non Patent Literature 1 has disclosed a method using a CNN (Convolutional Neural Network). Specifically, a grayscale image is used as the input to the CNN. The value of each pixel in the grayscale image is a value corresponding to the absolute value of a magnetic flux density inside a rotor. Further, the absolute value of the magnetic flux density inside the rotor is a value in a state where the mechanical angle of the rotor is fixed. In the technique described in Non Patent Literature 1, the average torque and torque ripple of the motor are estimated using such a CNN to which the grayscale image has been input.

### CITATION LIST

### NON PATENT LITERATURE

Non Patent Literature 1: H. Sasaki, Y. Hidaka and H. Igarashi, "Prediction of IPM Machine Torque Characteristics Using Deep Learning Based on Magnetic Field Distribution," in IEEE Access, vol. 10, pp. 60814-60822, 2022

### SUMMARY OF INVENTION

### TECHNICAL PROBLEM

However, in the technique described in Non Patent Literature 1, the input to a learned model is an image, and thus the dimension of explanatory variable (amount of information) becomes enormous. Therefore, the number of learning data to be used for learning of the CNN increases. Therefore, there is a risk that the calculation load, particularly during learning of an estimation model that estimates an evaluation index of the rotary electric machine becomes high.

The present invention has been made in consideration of such a problem as above, and an object thereof is to reduce the calculation load during learning of an estimation model that estimates an evaluation index of a rotary electric machine.

### SOLUTION TO PROBLEM

The estimation device of the present invention is an estimation device for estimating an evaluation index of a rotary electric machine including a rotor and a stator, the estimation device including: an explanatory variable acquisition part configured to acquire a magnetic flux density distribution in a gap between the rotor and the stator; and an evaluation index calculation part configured to calculate an estimated value of the evaluation index corresponding to the magnetic flux density distribution by using an estimation model created by learning a relationship between the magnetic flux density distribution in the gap and the evaluation index.

The estimation model creation device of the present invention is an estimation model creation device for creating an estimation model intended for estimating an evaluation index of a rotary electric machine including a rotor and a stator, the estimation model creation device including: a creation part configured to create the estimation model by learning a relationship between a magnetic flux density distribution in a gap between the rotor and the stator and the evaluation index.

The estimation method of the present invention is an estimation method of estimating an evaluation index of a rotary electric machine including a rotor and a stator, the estimation method including: an explanatory variable acquisition step of acquiring a magnetic flux density distribution in a gap between the rotor and the stator; and an evaluation index calculation step of calculating an estimated value of the evaluation index corresponding to the magnetic flux density distribution by using an estimation model created by learning a relationship between the magnetic flux density distribution in the gap and the evaluation index.

The estimation model creation method of the present invention is an estimation model creation method of creating an estimation model intended for estimating an evaluation index of a rotary electric machine including a rotor and a stator, the estimation model creation method including: a creation step of creating the estimation model by learning a relationship between a magnetic flux density distribution in a gap between the rotor and the stator and the evaluation index.

A first example of the program of the present invention causes a computer to function as each part of the estimation device.

A second example of the program of the present invention causes a computer to function as each part of the estimation model creation device.

### BRIEF DESCRIPTION OF DRAWINGS

[Fig. 1] Fig. 1 is a diagram illustrating an example of functional configurations of an estimation model creation device and an estimation device.
[Fig. 2] Fig. 2 is a view illustrating an example of a configuration of an IPMSM.
[Fig. 3] Fig. 3 is a view illustrating an example of a configuration of a simplified motor.
[Fig. 4] Fig. 4 is a view explaining an example of a magnetic flux density distribution consisting of magnetic flux densities to be included in an explanatory variable.
[Fig. 5] Fig. 5 is a view conceptually illustrating an example of first explanatory variable data.
[Fig. 6] Fig. 6 is a view conceptually illustrating an example of a learning data group.
[Fig. 7] Fig. 7 is a flowchart explaining an example of an estimation model creation method.
[Fig. 8] Fig. 8 is a flowchart explaining an example of an estimation method.
[Fig. 9] Fig. 9 is a diagram illustrating an example of a hardware configuration of the estimation model creation device.
[Fig. 10A] Fig. 10A is a view illustrating a first example of analysis results.
[Fig. 10B] Fig. 10B is a view illustrating a second example of the analysis results.

### DESCRIPTION OF EMBODIMENTS

Hereinafter, there will be explained an embodiment of the present invention while referring to the drawings.

Incidentally, the fact that objects to be compared such as lengths, positions, sizes, and intervals, are the same includes the case where they are strictly the same, as well as the case where they are different within a range that does not depart from the gist of the invention (for example, the case where they are different within a tolerance range defined at the time of design). Further, in each of the drawings, the x-y-z coordinates are used to indicate the orientation relationship in each drawing. In the x-y-z coordinates, the symbol with a black circle (●) within a white circle (∘) is a symbol indicating an arrow line indicating that the direction from a far side toward a near side of the paper sheet is a positive direction.

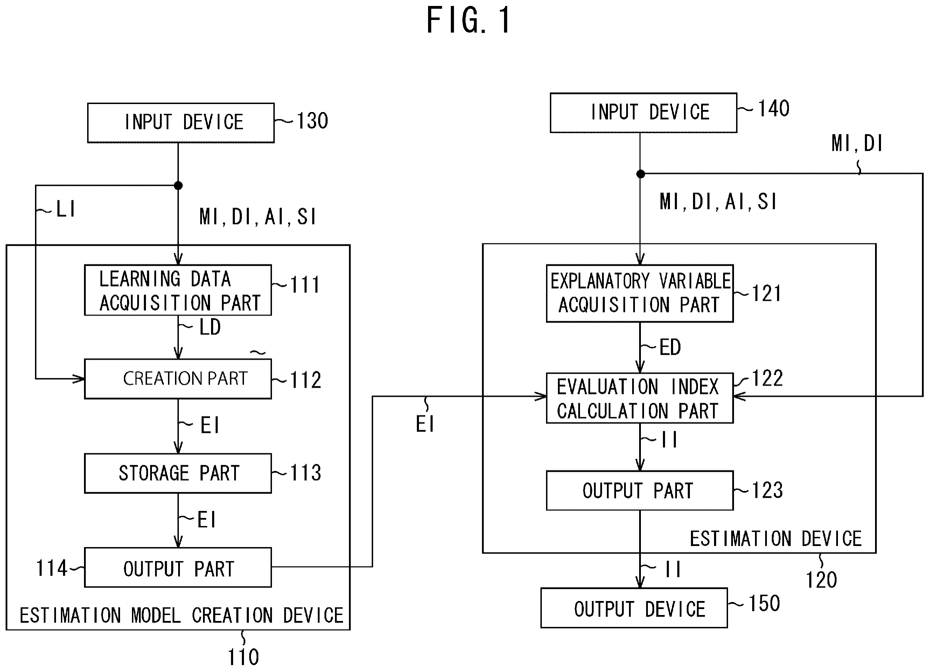

Fig. 1 is a diagram illustrating an example of functional configurations of an estimation model creation device 110 and an estimation device 120. The hardware of the estimation model creation device 110 and the hardware of the estimation device 120 are fabricated by using, for example, an information processing device including a processor, a main memory, an auxiliary memory, and various interfaces. Further, the estimation model creation device 110 and the estimation device 120 may also be fabricated by dedicated hardware such as an ASIC (Application Specific Integrated Circuit). Further, this embodiment explains, as an example, the case where the estimation model creation device 110 and the estimation device 120 are separate devices. However, at least some of the functions of one of the estimation model creation device 110 and the estimation device 120 may be provided in the other device.

The estimation device 120 estimates an evaluation index of a rotary electric machine. The estimation model creation device 110 creates an estimation model for estimating the evaluation index of the rotary electric machine. This embodiment explains, as an example, the case where the estimation device 120 estimates the evaluation index of the rotary electric machine using the estimation model created by the estimation model creation device 110.

The estimation model is a learned model that calculates an objective variable based on an explanatory variable. The estimation model is created by learning the relationship between the explanatory variable and the objective variable. Using the learned model as the estimation model makes it possible to estimate evaluation indexes of rotary electric machines having various structures without actually manufacturing the rotary electric machines. Therefore, it is possible to explore the structure of a rotary electric machine (rotor) that can be highly evaluated based on the evaluation index without actually manufacturing the rotary electric machine. For example, it is possible to explore the structure of a motor that can obtain a high torque without actually manufacturing the motor. In addition, it is no longer necessary to perform measurements using sensors during operation of the actually manufactured rotary electric machine.

This embodiment explains, as an example, the case where the evaluation index of the rotary electric machine is included in the objective variable of the estimation model. Further, this embodiment explains, as an example, the case where a plurality of magnetic flux densities are included in the explanatory variable of the estimation model. These plural magnetic flux densities represent a magnetic flux densily distribution in at least a partial region of an air gap formed between a rotor and a stator. The magnetic flux density distribution is, for example, a magnetic flux density distribution in an air gap that appears in a cut surface when the rotor is cut perpendicular to a rotation axis line at a predetermined position on the rotation axis line of the rotor. However, the magnetic flux density distribution may also be a magnetic flux density distribution in a three-dimensional space formed as the air gap. Incidentally, in the following explanation, the air gap is abbreviated to a gap as necessary.

Further, this embodiment explains, as an example, the case where the estimation model is created by performing supervised learning. However, this embodiment does not necessarily need to be designed in this manner. The estimation model may be created by performing unsupervised learning. In this case, correct answer labels to be explained in this embodiment are not required. Further, the estimation model may also be created by performing reinforcement learning.

Here, the present inventor has found out that the evaluation index of a rotary electric machine such as a motor is significantly affected by the magnetic flux density distribution in the vicinity of an outer periphery of a rotor. More specifically, the evaluation index of the rotary electric machine is determined primarily by the magnetic flux density distribution in the gap between the rotor and the stator (the distribution of magnetic flux density passing through the gap). Therefore, the present inventor has considered that it is possible to estimate the evaluation index of the rotary electric machine from the magnetic flux density distribution in the gap.

Further, generally, the magnetic flux density distribution during operation of the rotary electric machine is calculated by performing an electromagnetic field analysis using the finite element method or the like. In this case, a relatively long time is required to calculate the magnetic flux density distribution. Here, the present inventor has found out that the magnetic flux density distribution in the rotor and the magnetic flux density distribution in the stator are roughly determined by the arrangement of magnetic poles (for example, permanent magnets) in the rotor and the shape of a flux barrier formed in the rotor, provided that operating conditions of the rotary electric machine are the same. Further, there is a correlation between the magnetic flux density distribution calculated using an analysis model in which the stator has been simplified and the magnetic flux density distribution calculated using an analysis model in which the stator is not simplified. Then, when the electromagnetic field analysis is performed using the analysis model in which the stator has been simplified, the calculation of the magnetic flux density distribution can be performed in a shorter time than when the electromagnetic field analysis is performed using the analysis model in which the stator is not simplified. Therefore, the present inventor has considered that by using the analysis model in which the stator has been simplified, the electromagnetic field analysis of the magnetic flux density distribution in the gap can be performed in a shorter time, and therefore the estimation of the evaluation index of the rotary electric machine can be performed in a shorter time.

For example, as described in Non Patent Literature 1, when image data of a region constituting one pole of a rotor are input to the estimation model, the magnetic flux density of a region that has a low (or no) relevance to the evaluation index of the rotary electric machine, or the magnetic flux density of a region that hinders accurate calculation of the evaluation index of the rotary electric machine, can be included in the explanatory variable. Further, when the image data of the region constituting one pole of the rotor are input to the estimation model, the magnetic flux density at each pixel in the image data serves as an explanatory variable, and thus the dimension of the explanatory variable (amount of information) becomes enormous. For this reason, in order to improve the accuracy of the estimation model, various combinations of input values that constitute the explanatory variables are required. Therefore, a large amount of learning data is required, and at the same time, a lot of time is required to prepare the learning data (incidentally, as the number of learning data, 5222 is described in Non Patent Literature 1). Thus, this embodiment explains, as an example, the case where the data (data on magnetic flux density in the gap) to be input to the estimation model as an explanatory variable are not the image data. In the explanation of this embodiment, unless otherwise specified, it is assumed that the data on explanatory variable (magnetic flux density) are not the image data.

Further, this embodiment explains, as an example, the case where the rotary electric machine is an IPMSM (Interior Permanent Magnet Synchronous Motor). Here, an outline of the IPMSM is given.

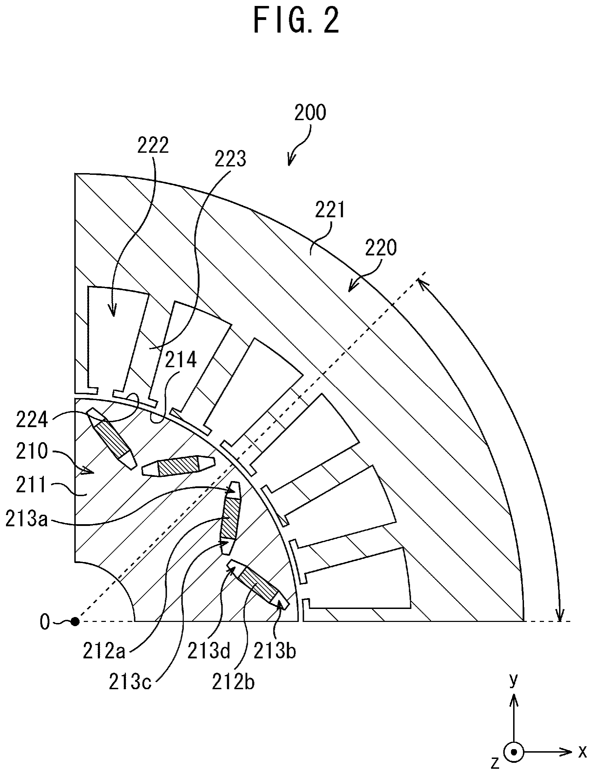

Fig. 2 is a view illustrating an example of a configuration of an IPMSM 200. Fig. 2 illustrates, as an example, a so-called V-shaped IPMSM in which permanent magnets as magnetic poles of a rotor are arranged in a V shape. Further, Fig. 2 illustrates, as an example, the case where the number of poles of the IPMSM 200 (a rotor 210) is eight (incidentally, the number of poles of the IPMSM 200 is not limited). In Fig. 2, the range indicated by the double-headed arrow line is a portion that constitutes one pole of the IPMSM 200. Incidentally, when the number of poles of the IPMSM 200 (the rotor 210) is n, the IPMSM 200 generally has a relationship of n-fold rotational symmetry with a rotation axis line 0 of the IPMSM 200 set as a rotational symmetry axis. n is an integer of 2 or more. In the example illustrated in Fig. 2, n is 8 (n = 8). Fig. 2 illustrates one of the four regions obtained by equally dividing a cut surface, which appears when the IPMSM 200 is cut perpendicular to the rotation axis line 0 of the IPMSM 200, into four parts. Therefore, Fig. 2 illustrates, of the region of the IPMSM 200, the region that constitutes two poles of the rotor 210. These four regions roughly have a 4-fold (= 8 poles ÷ 2) symmetrical relationship with the rotation axis line 0 of the IPMSM 200 set as the rotational symmetry axis. Thus, in Fig. 2, by rotating the region illustrated in Fig. 2 by 90° at a time with the center line of the IPMSM 200 set as the rotation axis line 0, the entire configuration of the cut surface that appears when the IPMSM 200 is cut perpendicular to the rotation axis line 0 of the IPMSM 200 is obtained. In the following explanation, the cut surface that appears when the IPMSM 200 is cut perpendicular to the rotation axis line 0 of the IPMSM 200 is referred to as a motor cross section, as necessary.

In Fig. 2, the IPMSM 200 includes the rotor 210 and a stator 220.

The stator 220 includes a stator core 221 and not-illustrated stator coils. The stator 220 generates a rotating magnetic field. Incidentally, in Fig. 2, the illustration of the stator coils included in the stator 220 is omitted. The not-illustrated stator coils are each arranged in each slot 222 of the stator core 221 (for convenience of notation, only one slot is marked with a reference numeral in Fig. 2). The winding method of the stator coil is not limited. The winding method of the stator coil may be distributed winding or concentrated winding.

The rotor 210 rotates with the rotation axis line 0 of the IPMSM 200 set as its rotation axis line. Therefore, a rotation axis line 0 of the rotor 210 and the rotation axis line 0 of the IPMSM 200 coincide with each other.

The rotor 210 includes a rotor core 211 and a plurality of permanent magnets. Fig. 2 illustrates, as an example, the case where the number of permanent magnets per one pole is two (see two permanent magnets 212a to 212b illustrated in Fig. 2). Incidentally, the number of permanent magnets per one pole is not limited. The number of permanent magnets per one pole may be one or may also be three or more. The rotor core 211 is formed using a soft magnetic material. For example, the rotor core 211 is formed by stacking a plurality of electrical steel sheets.

As described previously, Fig. 2 illustrates, as an example, the case where the plural permanent magnets 212a to 212b per one pole are installed in the rotor core 211. Therefore, in the rotor core 211, a plurality of magnet holes per one pole are formed along a direction parallel to a rotation axis line 0 of the rotor core 211 (in the following explanation, the direction parallel to the rotation axis line 0 is referred to as the z-axis direction as necessary). The magnet holes are through holes that penetrate in the z-axis direction. The plural permanent magnets 212a to 212b are installed (embedded) in the rotor core 211 by being inserted into the aforementioned magnet holes formed in the rotor core 211 respectively. As described previously, Fig. 2 illustrates, of the region of the IPMSM 200, the region that constitutes two poles of the rotor 210. Fig. 2 illustrates, as an example, the case where the two permanent magnets 212a to 212b per one pole are embedded in the rotor core 211. Therefore, 16 permanent magnets in total are embedded in the rotor core 211. Incidentally, in Fig. 2, for convenience of notation, of the portions that constitute two poles of the rotor 210, only the portion that constitutes one pole of the rotor 210 is marked with reference numerals and symbols.

In the aforementioned magnet holes formed in the rotor core 211, the space where the permanent magnets 212a to 212b are not present is flux barriers 213a to 213d. The flux barriers 213a to 213d are regions through which magnetic fluxes do not pass, or regions through which magnetic fluxes are more difficult to pass than the regions around the flux barriers 213a to 213d. Here, there is explained, as an example, the case where no material object is present in the flux barriers 213a to 213d (namely, the case where the flux barriers 213a to 213d are voids (air regions) is explained as an example). However, a nonmagnetic material may be installed in the flux barriers 213a to 213d. Further, the flux barriers do not need to be formed at positions adjacent to the permanent magnets 212a to 212b (namely, the flux barriers each do not need to be part of the magnet hole). The flux barriers may be formed at positions not adjacent to the permanent magnets 212a to 212b, in addition to or instead of being formed at the positions adjacent to the permanent magnets 212a to 212b.

Incidentally, the IPMSM itself may be any well-known IPMSM, and is not limited to the IPMSM 200 illustrated in Fig. 2. For example, skew may be applied to at least one of the rotor core and the stator core.

As above, this embodiment explains, as an example, the case where the rotary electric machine is a motor. Therefore, in the following explanation, the evaluation index of the rotary electric machine is referred to as a motor evaluation index as necessary. However, the rotary electric machine is not limited to the motor, and may be a generator. Further, the motor is not limited to the IPMSM illustrated in Fig. 2 as an example, and may be another motor. Further, the motor is not limited to the inner rotor type motor illustrated in Fig. 2 as an example, and may be an outer rotor type motor. Further, the motor is not limited to the radial gap type motor illustrated in Fig. 2 as an example, and may be an axial gap type motor.

Here, this embodiment explains, as an example, the case where the gap is a region from a facing surface of the rotor 210 to a facing surface of the stator 220. The facing surface of the rotor 210 is the surface of the rotor 210 (the rotor core 211) that faces the stator 220 with a clearance therebetween. In the inner rotor type motor illustrated in Fig. 2, the facing surface of the rotor 210 is an outer circumferential surface 214 of the rotor 210. Further, in the outer rotor type motor, the facing surface of the rotor is an inner circumferential surface of the rotor. The facing surface of the stator 220 is a tip surface 224 of teeth 223 of the stator 220. Thus, this embodiment explains, as an example, the case where the gap includes the facing surface of the rotor 210 and the facing surface of the stator 220.

### <Estimation model creation device 110>

There is explained in detail an example of the functions of the estimation model creation device 110 below. As illustrated in Fig. 1, this embodiment explains, as an example, the case where the estimation model creation device 110 includes a learning data acquisition part 111, a creation part 112, a storage part 113, and an output part 114.

### <<Learning data acquisition part 111>>

The learning data acquisition part 111 acquires learning data. The learning data are data to be used for creating (learning) an estimation model. As described previously, this embodiment explains, as an example, the case where the estimation model is created by performing supervised learning. In this case, the learning data include, for example, first explanatory variable data and first objective variable data. The first explanatory variable data are data on explanatory variable to be used when creating (learning) the estimation model. As described previously, this embodiment explains, as an example, the case where the data on a plurality of magnetic flux densities are included in the explanatory variable of the estimation model. The plural magnetic flux densities represent a magnetic flux density distribution in at least a partial region of the gap. Thus, this embodiment explains, as an example, the case where such plural magnetic flux densities are included in the first explanatory variable data. The first objective variable data are data on objective variable (so-called correct answer label) to be used when creating (learning) the estimation model. As described previously, this embodiment explains, as an example, the case where the motor evaluation index is included in the objective variable of the estimation model. Thus, this embodiment explains, as an example, the case where the motor evaluation index is included in the first objective variable data. The motor evaluation index (evaluation index) only needs to be any index that can be used for evaluating the motor. For example, the motor evaluation index is at least one of torque such as average torque, torque ripple, iron loss, and efficiency.

The data on plural magnetic flux densities that constitute the explanatory variable are, for example, data representing a magnetic flux density distribution in all or part of the gap at the same time. Further, the data on plural magnetic flux densities that constitute the explanatory variable may be data representing a magnetic flux density distribution only in all of the gap or in part of the gap. However, the data on plural magnetic flux densities that constitute the explanatory variable may include, for example, a value (distribution) of magnetic flux density in a core portion other than the gap. The core portion other than the gap includes, for example, at least one of the core portion around the gap in the core portion of the rotor 210 (a portion around the gap of the rotor core 211) and the core portion around the gap in the core portion of the stator 220 (a portion around the gap of the stator core 221). Thus, in the data on plural magnetic flux densities that constitute the explanatory variable, a value (distribution) of magnetic flux density in the portion other than the gap may be included. In this case, the data on plural magnetic flux densities that constitute the explanatory variable are preferably constituted so that the region exhibiting the magnetic flux density distribution in the gap is wider than the region exhibiting the magnetic flux density distribution in the other portion. Further, the data on plural magnetic flux densities that constitute the explanatory variable are also preferably constituted so that the region exhibiting the magnetic flux density distribution in the gap is the same as or approximately the same as the region exhibiting the magnetic flux density distribution in the other portion. Incidentally, the phrase of approximately the same includes both the case where the region exhibiting the magnetic flux density distribution in the gap is wider than the region exhibiting the magnetic flux density distribution in the other portion and the case where the region exhibiting the magnetic flux density distribution in the gap is narrower than the region exhibiting the magnetic flux density distribution in the other portion.

Incidentally, as described previously, the estimation model may also be created by performing unsupervised learning. In this case, in the learning data acquired by the learning data acquisition part 111, the first explanatory variable data may be included and the first objective variable data (correct answer labels) do not need to be included.

The form in which the learning data acquisition part 111 acquires the learning data is not limited. For example, the learning data acquisition part 111 may acquire the learning data by reading the learning data stored in a storage medium inside the estimation model creation device 110. Further, the learning data acquisition part 111 may acquire the learning data by receiving the learning data from an external device. Further, an operator may operate an input device 130 connected to the estimation model creation device 110, to thereby input a numerical value indicating the learning data to the estimation model creation device 110. In this case, the learning data storage part 111 may acquire the learning data input in this manner. Further, at least one of the data on motor evaluation index included in the first objective variable data and the data on plural magnetic flux densities included in the first explanatory variable data may be, for example, a measured value. However, it is more efficient to perform a numerical analysis such as the finite element method rather than fabricating various motors and performing measurements. Therefore, this embodiment explains, as an example, the case where the learning data acquisition part 111 acquires the learning data by calculating the learning data as follows.

### <<<Calculation of the first objective variable data>>>

First, there is explained an example of a method in which the learning data acquisition part 111 calculates the first objective variable data. This embodiment explains, as an example, the case where the learning data acquisition part 111 calculates the motor evaluation index as the first objective variable data by performing an electromagnetic field analysis (numerical analysis) on the motor.

As in the previously-described findings found by the present inventor, the motor evaluation index such as torque depends more heavily on the magnetic flux density distribution in the gap than on the configuration of the rotor 210 itself. Thus, this embodiment explains, as an example, the case where in order to create a plurality of pieces of learning data, a plurality of motors in which configurations of at least some of the rotors 210 are different from one another are used as the motor being a target for calculating the first objective variable data (motor evaluation index). In the following explanation, the motor being a target for calculating the motor evaluation index during learning is referred to as a learning motor as necessary. Further, the IPMSM 200 illustrated in Fig. 2 can be one of the learning motors. Therefore, in the following explanation, the reference numerals and symbols used in Fig. 2 are given as the reference numerals and symbols for the learning motor as necessary to make explanations.

This embodiment explains, as an example, the case where the configuration of the rotor 210 that is made to differ from one another among a plurality of learning motors 200 is at least one of at least one of the shape of the permanent magnets 212a to 212b and the number of permanent magnets 212a to 212b, at least one of the shape of the flux barriers 213a to 213d and the number of flux barriers 213a to 213d, and the shape of the facing surface of the rotor 210. In the example illustrated in Fig. 2, the facing surface of the rotor 210 is the outer circumferential surface 214 of the rotor 210. Incidentally, the configuration of the rotor 210 that is made to differ from one another among the plural learning motors 200 is not limited to these.

However, a predetermined attribute of the rotor 210 may be the same in at least some of the learning motors 200. The predetermined attribute of the rotor 210 may be determined based on, for example, the degree of effect on the motor evaluation index (whether or not the accuracy of the motor evaluation index is significantly affected unless the attribute is made the same). The predetermined attribute of the rotor 210 includes, for example, at least one of an outside diameter, an inside diameter, and the number of poles. In the following explanation, the predetermined attribute of the rotor 210 is referred to as a rotor fixed attribute as necessary. Incidentally, in the previously-described example, when two or more of the attributes of the outside diameter, the inside diameter, and the number of poles, for example, are made the same in at least some of the learning motors 200, the rotor fixed attribute is represented by a set of the two or more attributes. In other words, in this case, the rotor fixed attributes being the same means that all of the two or more attributes are the same. On the other hand, the rotor fixed attributes being different means that one or more of the two or more attributes are different.

This embodiment explains, as an example, the case where when the rotor fixed attributes of the plural motors being a target for estimating the motor evaluation index by the estimation device 120 are different from one another, the motor evaluation indexes of the plural motors are estimated by different estimation models. That is, this embodiment explains, as an example, the case where the estimation model creation device 110 creates an estimation model for each rotor fixed attribute. Incidentally, in the following explanation, the motor being a target for estimating the motor evaluation index by the estimation device 120 is referred to as an estimation motor as necessary. Further, in the following explanation, the number of plural learning motors to be used for creating (learning) one estimation model is described as s as necessary.

The learning data acquisition part 111 receives driving condition information DI of the learning motor 200 and motor configuration information MI of the learning motor 200 as the information necessary for calculating the first objective variable data (motor evaluation index).

The driving condition information DI of the learning motor 200 is information that indicates a driving condition of the learning motor 200 (in the following explanation, the driving condition of the motor is abbreviated to a driving condition as necessary). In the driving condition, for example, a rotation speed, an amplitude of stator current (excitation current), and a lead angle are included.

The motor configuration information MI of the learning motor 200 is information that indicates the configuration of the learning motor 200. In the information that indicates the configuration of the learning motor 200, for example, information on component of the learning motor 200 is included. Examples of the component include, for example, the rotor core 211, the permanent magnets 212a to 212b, and the stator core 221. Further, in the information on component, for example, pieces of information indicating the number, position, size, shape, and material (physical property value) of each of the components are included. In the motor configuration information MI of the learning motor 200, information indicating each of the configurations of s pieces of the learning motors 200 may be included. Further, in the motor configuration information MI of the learning motor 200, for example, information indicating the configuration of one or less than s pieces of the learning motors 200, and information indicating how to modify the configuration of the rotor 210 for the one or less than s pieces of the learning motors 200 may be included.

The learning data acquisition part 111 creates shape data for each of s pieces of the learning motors 200 based on the motor configuration information MI of the learning motor 200. In the shape data on the motor, for example, information indicating the region (coordinate range) occupied by each component of the motor in a coordinate plane (or coordinate space) is included (this is also true for pieces of shape data on motors other than the learning motor 200).

Besides, the learning data acquisition part 111 receives analysis condition information AI. The analysis condition information AI is information that needs to be set when performing an electromagnetic field analysis method such as the finite element method. For example, in the analysis condition information AI, pieces of information on position, size, and shape of a minute region (mesh) are included. The minute region (mesh) is set in an analysis target region including, for example, a region of the motor. The analysis target region is set in the coordinate plane (or coordinate space). Further, in the minute region (mesh), a physical property value of a region where the minute region is set, and so on are set.

Incidentally, this embodiment explains, as an example, the case where an operator operates the input device 130 connected to the estimation model creation device 110, to thereby input numerical values indicating these pieces of information (the driving condition information DI, the motor configuration information MI, and the analysis condition information AI) to the estimation model creation device 110. In this case, the learning data acquisition part 111 acquires the numerical values input in this manner as the driving condition information DI, the motor configuration information MI, and the analysis condition information AI. However, the input form of these pieces of information is not limited. For example, the learning data acquisition part 111 may receive these pieces of information from an external device, or may read these pieces of information from a storage medium.

The learning data acquisition part 111 calculates the motor evaluation index when each of s pieces of the learning motors 200 is driven (rotated) under the same driving condition by performing an electromagnetic field analysis (numerical analysis) using a method such as the finite element method.

To achieve this, first, the learning data acquisition part 111 performs, for example, using the finite element method or the like, based on the Maxwell equation, calculation of a magnetic flux density vector and an eddy current vector in each minute region (mesh) of the learning motor 200 when the learning motor 200 is driven (rotated), for each of s pieces of the learning motors 200 under the same driving condition.

This embodiment explains, as an example, the case where the learning data acquisition part 111 calculates such magnetic flux density vector and eddy current vector for at least one cycle at each time of a predetermined time step.

Then, the learning data acquisition part 111 calculates the motor evaluation index based on at least one of the magnetic flux density vector and the eddy current vector in each minute region (mesh). For example, when torque is included in the motor evaluation index, the learning data acquisition part 111 calculates, for example, a Maxwell stress as the torque.

This embodiment explains, as an example, the case where the configuration of the motor cross section does not change in the height direction (the z-axis direction) in respective motors, including the learning motor 200 and a later-described simplified motor 300. Therefore, there is explained, as an example, the case where a two-dimensional analysis on the motor cross section is performed as the electromagnetic field analysis. Thus, in the shape data on the previously-described motor, for example, information indicating the region (coordinate range) occupied by each component of the motor in the coordinate plane is included. However, as the electromagnetic field analysis, an analysis in the direction of the motor cross section (the x-axis direction and the y-axis direction) and in the height direction (the z-axis direction) (three-dimensional analysis) may be performed. In this case, in the shape data on the previously-described motor, for example, information indicating the region (coordinate range) occupied by each component of the motor in the coordinate space is included.

Incidentally, the method of the electromagnetic field analysis by the finite element method itself is a common method, and thus its detailed explanation is omitted here.

In the manner described above, the learning data acquisition part 111 calculates, as the motor evaluation index for each of s pieces of the learning motors 200, the motor evaluation index in the case where the driving conditions for s pieces of the learning motors 200 are the same. Further, when creating an estimation model for each driving condition, the learning data acquisition part 111 calculates the motor evaluation index for each of s pieces of the learning motors 200 for each of the plural driving conditions. Further, when creating an estimation model for each of the previously-described rotor fixed attributes, the learning data acquisition part 111 calculates the motor evaluation index for each of s pieces of the learning motors 200 for each rotor fixed attribute. As described above, this embodiment explains, as an example, the case where the motor evaluation index as the first objective variable data is calculated as an example of an actual value of the evaluation index of the rotary electric machine for each rotor fixed attribute, for each driving condition, and for each learning motor.

### <<<Calculation of the first explanatory variable data>>>

Next, there is explained an example of a method in which the learning data acquisition part 111 calculates the first explanatory variable data.

As described above in the section <<<Calculation of the first objective variable data>>>, the motor evaluation index such as torque is determined from the distribution of magnetic flux density passing through the gap between the rotor 210 and the stator 220, and therefore is highly dependent on the magnetic flux density distribution in the gap. Further, as long as the driving conditions are the same, the magnetic flux density distributions near the facing surface of the rotor 210 and near the facing surface of the stator 220 are roughly determined by magnetic poles of the rotor 210 (the permanent magnets 212a to 212b in the example illustrated in Fig. 2) and the flux barriers 213a to 213d formed in the rotor core 211. In order to accurately obtain the magnetic flux density distribution during driving of the motor, measurements on the learning motor 200 and an electromagnetic field analysis (numerical analysis) on the learning motor 200 are usually performed.

However, as described previously, there is a correlation between the magnetic flux density distribution in the gap calculated for the motor in which the stator 220 has been simplified and the magnetic flux density distribution calculated for the motor in which the stator 220 is not simplified. The present inventor has focused on this fact and come up with the idea of acquiring data on explanatory variable to be used for learning (first explanatory variable data) by using data on the magnetic flux density generated in a motor in which at least part of the configuration of the stator has been simplified for the motor being a target for calculating the motor evaluation index. In the following explanation, the motor in which the stator has been simplified is referred to as a simplified motor as necessary.

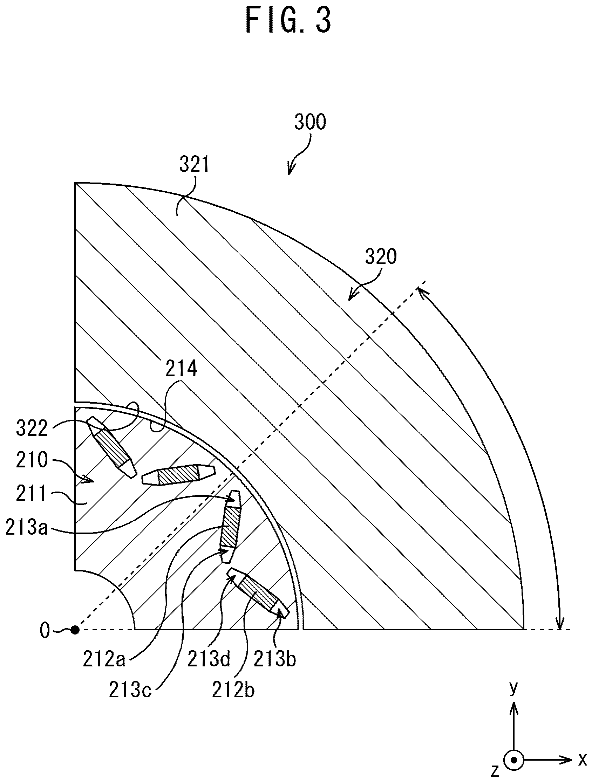

Fig. 3 is a view illustrating an example of the configuration of the simplified motor 300. In Fig. 3, the simplified motor 300 includes a rotor 210 and a stator 320. Fig. 3 illustrates, as an example, the case where the rotor 210 of the learning motor 200 and the rotor 210 of the simplified motor 300 are the same. However, the rotor 210 of the learning motor 200 and the rotor 210 of the simplified motor 300 do not need to be the same. In this case, it is preferable that there should be a correlation between the magnetic flux density distribution generated from magnetic poles of the rotor of the simplified motor 300 and the magnetic flux density distribution generated from magnetic poles (the permanent magnets 212a to 212b) of the rotor 210 of the learning motor 200.

Fig. 3 illustrates, as an example, the case where the stator 320 of the simplified motor 300 includes a stator core 321 and does not include stator coils. Further, this embodiment explains, as an example, the case where the stator core 321 does not include the teeth 223 in contrast to the stator core 221 of the learning motor 200, by making the region of the slots 222 into a region of soft magnetic material that forms the stator core 321. In this case, the shape of the stator core 321 is, for example, a hollow cylinder. Incidentally, the inside diameter, the outside diameter, and the height (length in the z-axis direction) of the stator core 321 are the same as those of the stator core 221. Further, in Fig. 3, the range indicated by the double-headed arrow line is a portion that constitutes one pole of the simplified motor 300.

The learning data acquisition part 111 calculates the magnetic flux density vector in the gap of the simplified motor 300 by performing an electromagnetic field analysis (numerical analysis) on the simplified motor 300. The learning data acquisition part 111 receives simplified stator information SI for the learning motor 200 as the information necessary for calculating the magnetic flux density vector in the gap of the simplified motor 300. The simplified stator information SI for the learning motor 200 is information that indicates the configuration of the stator 320 of the simplified motor 300 in which the stator 220 of the learning motor 200 has been simplified. In the information indicating the configuration of the stator 320 of the simplified motor 300, for example, pieces of information indicating the number, position, size, shape, and material (physical property value) of each of the components of the stator 320 are included. In the simplified stator information SI for the learning motor 200, the information on the configuration of the stator 320 itself does not need to be included. For example, in the simplified stator information SI for the learning motor 200, information indicating how to modify the stator 220 of the learning motor 200 may be included.

Incidentally, this embodiment explains, as an example, the case where an operator operates the input device 130 connected to the estimation model creation device 110, to thereby input a numerical value indicating the simplified stator information SI for the learning motor 200 to the estimation model creation device 110. In this case, the learning data acquisition part 111 acquires the numerical value input in this manner as the simplified stator information SI. However, as with the previously-described driving condition information DI or the like, the input form of the simplified stator information SI for the learning motor 200 is also not limited.

The learning data acquisition part 111 creates shape data of the simplified motor 300 based on, for example, the motor configuration information MI of the learning motor 200 and the simplified stator information SI for the learning motor 200.

The electromagnetic field analysis is performed, for example, in the same manner as the electromagnetic field analysis on the learning motor 200, by using the finite element method or the like based on the Maxwell equation. As described previously, in this case, the magnetic flux density vector in each minute region (mesh) is calculated (incidentally, in the finite element method, the eddy current vector can also be calculated in addition to the magnetic flux density vector). However, the stator 320 of the simplified motor 300 does not include the stator coils. Therefore, the learning data acquisition part 111 does not need to perform the electromagnetic field analysis in a state of the simplified motor 300 rotating. Therefore, the learning data acquisition part 111 performs the electromagnetic field analysis, for example, by setting the rotation speed, the amplitude of stator current, and the lead angle, which are used as the driving conditions during the electromagnetic field analysis on the learning motor 200, to 0 (zero). In this case, the magnetic flux density distribution generated from the permanent magnets 212a to 212b of the rotor 210 is calculated in a state of the rotor 210 being stationary. When the rotor 210 does not rotate, the magnetic flux density distribution does not change with time. Further, when the stator 320 includes only the stator core having a hollow cylindrical shape, the magnetic flux density distribution does not depend on the position of the permanent magnets 212a to 212b in the original direction of rotation (circumferential direction) of the rotor 210. Therefore, the learning data acquisition part 111 only needs to perform the calculation of the magnetic flux density vector of the simplified motor 300 at one time. This embodiment explains, as an example, the case where the learning data acquisition part 111 performs the calculation of the magnetic flux density vector of the simplified motor 300 at one time, in order to minimize the calculation load. However, the calculation of the magnetic flux density vector of the simplified motor 300 may be performed, for example, at a plurality of times within a period of less than one cycle, or may also be performed at a plurality of times within a period of one cycle or a period of longer than one cycle. Incidentally, one cycle in the electromagnetic field analysis is the range from 0 [rad] to 2π [rad] of an electrical angle.

This embodiment explains, as an example, the case where the simplified motor 300 does not include the stator coils or the teeth 223 (the slots 222). Further, this embodiment explains, as an example, the case where the stator 320 has a relationship of q-fold rotational symmetry (q is any positive number) with the center line of the simplified motor 300 (the original rotation axis line 0 of the rotor 210) set as a rotational symmetry axis. In these cases, the calculation of the magnetic flux density vector of the simplified motor 300 only needs to be performed at one time. Therefore, this is preferable as the calculation load can be greatly reduced. However, this embodiment does not necessarily need to be designed in this manner. For example, the stator of the simplified motor may include the teeth 223 (the slots 222), and does not need to include the stator coils. Further, the stator of the simplified motor may include the stator coils, and does not need to include the teeth 223 (the slots 222) (incidentally, in this case, the stator coils are embedded in the stator core). Further, the stator 220 may be simplified by at least one of the following: making the number of teeth of the stator of the simplified motor less than the number of teeth 223 of the learning motor 200; and eliminating the configuration of a portion of one teeth 223. Eliminating the configuration of a portion of one teeth 223 may include, for example, eliminating the portions of the teeth 223 at the tip surface 224 that protrude toward the slot 222 side. Further, the stator coil may be simplified by reducing the number of turns of the stator coil, for example. Further, the stator 220 may be simplified by modifying the configurations of all or some of the stator coils and the teeth 223 (the slots 222), in addition to or instead of eliminating the configurations of all or some of the stator coils and the teeth 223 (the slots 222). For example, the stator 220 may be simplified by making contour lines of at least one of the stator coils and the teeth 223 approximate straight lines or curves with a constant curvature in the motor cross section. Incidentally, in this case, the reduction in calculation load can be achieved by coarsening the minute region (mesh), for example.

Further, among the components of the motor (for example, the IPMSM 200), the components other than the stator 220 may be simplified. However, the simplification is preferably performed so that the degree of change in the magnetic flux density distribution of the motor after simplification relative to the magnetic flux density distribution of the motor before simplification is greater when the stator 220 is simplified than when the components other than the stator 220 among the components of the motor are simplified. For example, the simplification may be performed so that the degree of change in the magnetic flux density distribution of the rotary electric machine after simplification relative to the magnetic flux density distribution of the motor before simplification is greater when only the stator 220 among the components to be simplified is simplified than when all of the components other than the stator 220 among the components to be simplified are simplified. Further, the simplification may be performed so that the degree of change in the magnetic flux density distribution of the motor after simplification relative to the magnetic flux density distribution of the motor before simplification is greater when only the stator 220 among the components to be simplified is simplified than when any one or more components other than the stator 220 among the components to be simplified are simplified.

Further, when the simplification of the stator 220 allows the magnetic flux density distribution for one cycle of the simplified motor to be calculated without performing an electromagnetic field analysis for one cycle by utilizing the rotational symmetry of the magnetic flux density distribution or another means, the learning data acquisition part 111 may calculate the magnetic flux density distribution of the simplified motor 300 at a plurality of times within a period of less than one cycle.

Further, when the rotor 210 does not rotate due to the simplification of the stator 220 and the magnetic flux density distribution of the simplified motor changes depending on the position of the permanent magnets 212a to 212b in the original direction of rotation of the rotor 210, the learning data acquisition part 111 may calculate the magnetic flux density distribution of the simplified motor only at that position.

Further, when it is possible to calculate the magnetic flux density distribution for one cycle of the simplified motor with the same level of accuracy as when performing an electromagnetic field analysis on the motor before simplification by utilizing the rotational symmetry of the magnetic flux density distribution or another means, even if a time step is made longer than the time step required when performing an electromagnetic field analysis on the motor before simplification, the learning data acquisition part 111 may calculate the magnetic flux density distribution of the simplified motor at each time of the longer time step. When utilizing the rotational symmetry of the magnetic flux density distribution as described above, for example, it is preferable that the stator of the simplified motor should have a relationship of n-fold rotational symmetry with the center line of the simplified motor (the original rotation axis line 0 of the rotor 210) set as the rotational symmetry axis (as described previously, n is the number of poles of the rotor 210).

As above, the stator 320 of the simplified motor 300 does not need to include the stator coils. In this case, as the magnetic flux density vector of the simplified motor 300, the magnetic flux density vector in a state of the simplified motor 300 being not in operation (namely, a state of the rotor 210 not rotating) is calculated. Further, the stator of the simplified motor 300 may include the stator coils. In this case, as the magnetic flux density vector of the simplified motor 300, the magnetic flux density vector in a state of the simplified motor 300 being in operation (namely, a state of the rotor 210 rotating) is calculated. As described above, when calculating the magnetic flux density vector of the simplified motor 300, whether or not the simplified motor 300 is in operation is not required. The magnetic flux density distribution in a state of magnetic fluxes being generated from at least the magnetic poles (for example, the permanent magnets 212a to 212b) of the rotor only needs to be acquired as the magnetic flux density distribution in the gap of the simplified motor 300.

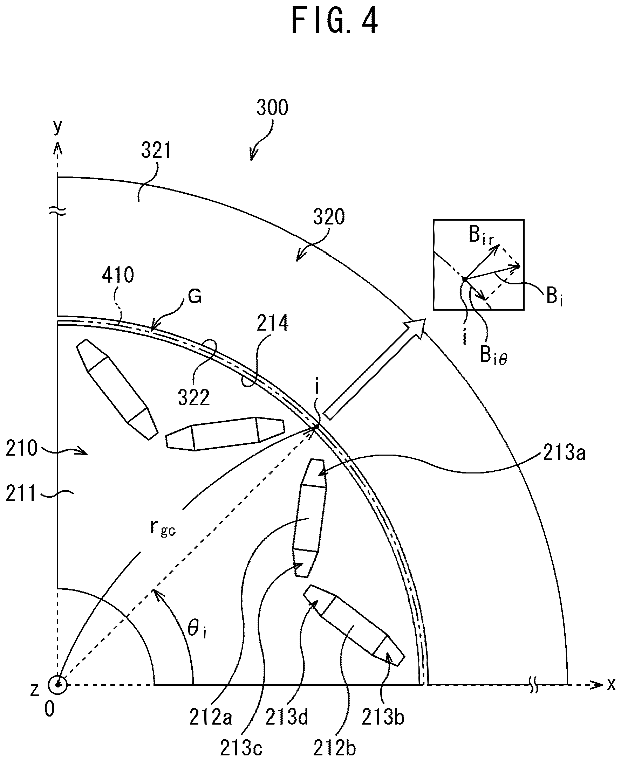

This embodiment explains, as an example, the case where the learning data acquisition part 111 calculates the first explanatory variable data based on such a magnetic flux density vector in the gap of the simplified motor 300 as described above. Fig. 4 is a view explaining an example of a magnetic flux density distribution consisting of a plurality of magnetic flux densities to be included in the explanatory variable. Incidentally, in Fig. 4, r and θ represent a radius vector and an argument in polar coordinates (circular coordinates) respectively. Further, in Fig. 4, hatching indicating a cross section is omitted in order to avoid the complexity of the notation.

Fig. 4 illustrates, as an example, the case where the position of the rotation axis line 0 in the motor cross section is an origin 0 of the polar coordinates and the x-y-z coordinates. Further, the direction from the origin 0 toward the outer side is set as the positive direction of a radius vector direction (radial direction of the motor) (in the following explanation, the radial direction of the motor is abbreviated to a radial direction as necessary). Further, the counterclockwise direction when facing the paper sheet is set as the positive direction of the argument. Incidentally, the outer side is the side where the outer circumferential surface 214 of the rotor core 211 is present. Further, as described previously, this embodiment explains, as an example, the case where the two-dimensional analysis on the motor cross section is performed as the electromagnetic field analysis. When an analysis in the direction of the motor cross section (the x-axis direction and the y-axis direction) and in the height direction (the z-axis direction) (three-dimensional analysis) is performed as the electromagnetic field analysis, cylindrical coordinates, for example, are used as the polar coordinates.

Fig. 4 illustrates, as an example, the case where the magnetic flux density distribution consisting of a plurality of magnetic flux densities to be included in the explanatory variable is a magnetic flux density distribution in a gap center region 410 in this embodiment. The gap center region 410 is a region that passes through the center of a gap G and is along the original direction of rotation of the rotor 210. The center of the gap G is located at a position where the distance from the outer circumferential surface 214 (facing surface) of the rotor 210 (the rotor core 211) is the same as the distance from an inner circumferential surface 322 (facing surface) of the stator 320 (the stator core 321). In this embodiment, the magnetic flux density distribution in the gap center region 410 is an example of a set of magnetic flux densities at each of a plurality of positions along the circumferential direction of the rotor 210. As described previously, this embodiment explains, as an example, the case where the two-dimensional analysis on the motor cross section is performed as the electromagnetic field analysis. Therefore, the shape of the gap center region 410 is, for example, a circle or a circular arc. Further, the gap center region 410 is a curved region along the original direction of rotation of the rotor 210. Incidentally, when an analysis in the direction of the motor cross section (the x-axis direction and the y-axis direction) and in the height direction (the z-axis direction) (three-dimensional analysis) is performed as the electromagnetic field analysis, the gap center region 410 has, for example, a shape of a side surface of a right circular cylinder, or a shape of a side surface of a right cylinder whose bottom surface is fan-shaped. Further, in this case, the gap center region 410 is a curved region along the original direction of rotation of the rotor 210.

As illustrated in Fig. 4, when the data on plural magnetic flux densities constituting the magnetic flux density distribution in the gap center region 410 are included in the explanatory variable, the learning data acquisition part 111 calculates the first explanatory variable data based on a magnetic flux density vector Bᵢ at each position i in the gap center region 410. A radius vector r_{gc} to each position i in the gap center region 410 (distance in the radius vector direction from the origin 0) does not vary regardless of the position i. On the other hand, an argument θᵢ to each position i in the gap center region 410 varies depending on the position i. Each position i in the gap center region 410 is determined in a manner to correspond to the position where a discretization calculation is performed in the electromagnetic field analysis. When the finite element method is used as a method of the electromagnetic field analysis, for example, each one position i is determined for each minute region including the gap center region 410. This embodiment explains, as an example, the case where the position where the distance in the radius vector direction from the origin 0 is r_{gc} is a specified position in the radial direction of the gap.

Incidentally, in Fig. 4, only one i being a reference symbol for each position in the gap center region 410 is illustrated for convenience of notation. This embodiment explains, as an example, the case where an r-direction component (radial direction component) Bᵢᵣ and a θ-direction component (circumferential direction component) B_{iθ} of the magnetic flux density vector Bᵢ at each position i in the gap center region 410 are included in the first explanatory variable data. In Fig. 4, the r-direction component Bᵢᵣ and the θ-direction component B_{iθ} of the magnetic flux density vector Bᵢ are illustrated in a rectangular region indicated by the white arrow line in a manner to enlarge the vicinity of the position i illustrated in Fig. 4. In this embodiment, the r-direction component Bᵢᵣ and the θ-direction component B_{iθ} of the magnetic flux density vector Bᵢ are an example of component values of the magnetic flux density vector. Incidentally, when direction components of the magnetic flux density vector are decomposed in an orthogonal coordinate system, an x-axis direction component and a y-axis direction component of the magnetic flux density vector Bᵢ may be included in the first explanatory variable data instead of the r-direction component Bᵢᵣ and the θ-direction component B_{iθ} of the magnetic flux density vector Bᵢ.

Incidentally, the magnetic flux density distribution in one or more regions passing through a position in the gap G other than the center of the gap G and along the original direction of rotation of the rotor 210, in addition to or instead of the gap center region 410, may be included as the magnetic flux density distribution constituting the data on plural magnetic flux densities to be included in the explanatory variable. For example, the magnetic flux density distribution in a region along the original direction of rotation of the rotor 210 at the position of the outer circumferential surface 214 (facing surface) of the rotor 210 (the rotor core 211) may be included as the magnetic flux density distribution constituting the data on plural magnetic flux densities to be included in the explanatory variable. Further, only in a void portion (air region) of the region of the gap G, the magnetic flux density distribution in the region along the original direction of rotation of the rotor 210 may be included as the magnetic flux density distribution constituting the data on magnetic flux density to be included in the explanatory variable. Incidentally, the void portion included in the region of the gap G consists, for example, of a region other than the region of the outer circumferential surface 214 (facing surface) of the rotor 210 (the rotor core 211) and a region other than the region of the inner circumferential surface 322 (facing surface) of the stator 320 (the stator core 321) of the region of the gap G.

As above, this embodiment explains, as an example, the case where the r-direction component Bᵢᵣ and the θ-direction component B_{iθ} of the magnetic flux density vector Bᵢ at each position i of the gap center region 410 of the simplified motor 300 are included in the first explanatory variable data.

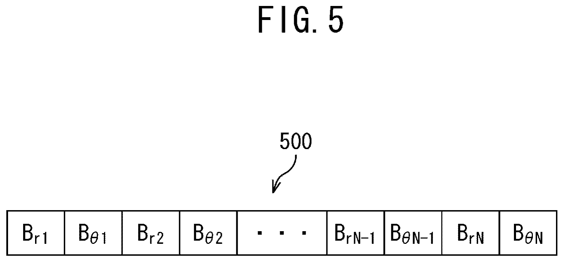

Fig. 5 is a view conceptually illustrating an example of first explanatory variable data 500. Fig. 5 illustrates, as an example, the case where the number of positions i in the gap center region 410 is N (i = 1 to N). For example, Bᵣ₁ and B_{θ1} represent an r-direction component and a θ-direction component of a magnetic flux density vector B₁ at the position i (= 1) in the gap center region 410. Fig. 5 illustrates, as an example, the case where each data included in the first explanatory variable data 500 are stored in a one-dimensional array. However, each data included in the first explanatory variable data 500 may be stored in a multidimensional array having two or more dimensions. In the following explanation, the r-direction component and the θ-direction component of the magnetic flux density vector are collectively referred to as a direction component of the magnetic flux density vector as necessary. Incidentally, as described previously, for example, at each of a plurality of positions in the radial direction within the gap G, magnetic flux density distributions in a plurality of regions defined along the original direction of rotation of the rotor 210 may be included as the magnetic flux density distribution constituting the data on plural magnetic flux densities to be included in the explanatory variable. In this case as well, each data included in the first explanatory variable data 500 may be stored in a one-dimensional array or a multidimensional array.

Further, this embodiment explains, as an example, the case where the values of the direction components Bᵢᵣ and B_{iθ} of the magnetic flux density vector included in the first explanatory variable data 500 are expressed in units of magnetic flux density (for example, tesla in the SI unit system, gauss in the CGS unit system). However, the values of the direction components Bᵢᵣ and B_{iθ} of the magnetic flux density vector included in the first explanatory variable data 500 may be values that can be converted into units of magnetic flux density. For example, the values of the direction components Bᵢᵣ and B_{iθ} of the magnetic flux density vector included in the first explanatory variable data 500 may be normalized values. In this case, the direction components Bᵢᵣ and B_{iθ} of the magnetic flux density vector included in the first explanatory variable data 500 are dimensionless quantities. Incidentally, in this embodiment, the first explanatory variable data 500 are not image data, and therefore the values of the direction components Bᵢᵣ and B_{iθ} of the magnetic flux density vector included in the first explanatory variable data 500 are not pixel values (for example, integer values from 0 to 255 in an 8-bit image).

The data on magnetic flux density to be included in the first explanatory variable data 500 are not limited to the data on the direction components Bᵢᵣ and B_{iθ} of the magnetic flux density vector Bᵢ. The data on magnetic flux density to be included in the first explanatory variable data 500 may be, for example, the phase and amplitude of spatial harmonics of the magnetic flux density. The values of phase and amplitude of the spatial harmonics of the magnetic flux density are preferably calculated for each of the direction components (for example, the r-direction component and the θ-direction component) of the magnetic flux density. Incidentally, an order m (the value of m) of the spatial harmonics is not limited. Further, the number of orders m of the spatial harmonics is also not limited. Further, the data on magnetic flux density to be included in the first explanatory variable data 500 may be the magnetic flux density vector Bi itself, or the absolute value of the magnetic flux density vector Bᵢ. Further, the data on magnetic flux density to be included in the first explanatory variable data 500 may be data based on image data (data in which each pixel value corresponds to a magnetic flux density) representing the magnetic flux density distribution of the entire simplified motor 300, as described in Non Patent Literature 1. In this case, the learning data acquisition part 111 may extract pixel data of each of the positions (pixels) of the data on plural magnetic flux densities to be included in the explanatory variable, such as the position of the gap center region 410, and include data on magnetic flux density based on the pixel data in the first explanatory variable data 500.

In the manner described above, the learning data acquisition part 111 calculates the first explanatory variable data 500 for each of s pieces of the simplified motors 300 in which the stators 220 of s pieces of the learning motors 200 have been simplified. Further, when the estimation model is created for each driving condition, the learning data acquisition part 111 calculates the first explanatory variable data 500 for each of s pieces of the simplified motors 300 for each of the plural driving conditions. Incidentally, this embodiment explains, as an example, the case where the first explanatory variable data 500 of the simplified motor 300 do not vary depending on the driving conditions. Therefore, the first explanatory variable data 500 of s pieces of the simplified motors 300 for one driving condition may be set as the first explanatory variable data 500 of s pieces of the simplified motors 300 for all driving conditions. In this case, the calculation of the first explanatory variable data 500 for each driving condition becomes unnecessary. However, the first explanatory variable data 500 of the simplified motor 300 may vary depending on the driving conditions. Further, when the estimation model is created for each of the previously-described rotor fixed attributes, the learning data acquisition part 111 calculates the first explanatory variable data 500 for each of s pieces of the simplified motors 300 for each rotor fixed attribute. As described above, this embodiment explains, as an example, the case where the first explanatory variable data 500 are calculated for each rotor fixed attribute, for each driving condition, and for each learning motor.

### <<<Creation of the learning data>>>

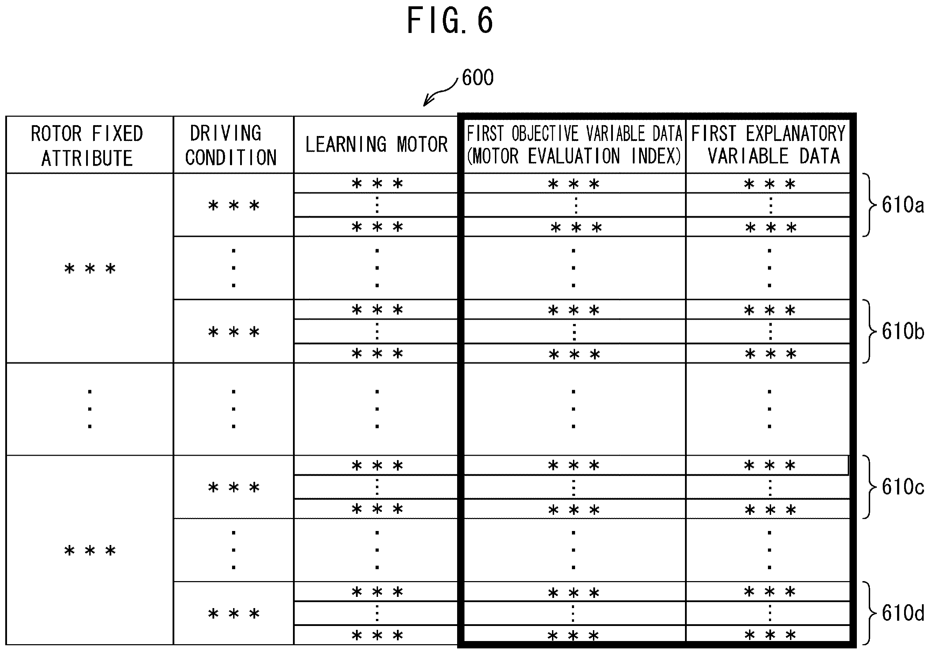

As described above in the sections <<<Calculation of the first objective variable data>>> and <<<Calculation of the first explanatory variable data>>>, this embodiment explains, as an example, the case where the first objective variable data (motor evaluation index) and the first explanatory variable data 500 are each calculated for each rotor fixed attribute, for each driving condition, and for each learning motor. Thus, the learning data acquisition part 111 associates the first objective variable data and the first explanatory variable data 500 whose rotor fixed attributes, driving conditions, and learning motors are the same, with each other among pieces of the first objective variable data (motor evaluation indexes) and pieces of the first explanatory variable data 500 to create single learning data. Fig. 6 is a view conceptually illustrating an example of a learning data group 600. In Fig. 6, "***" indicates that information (such as numerical values) is stored. Further, "..." lined up virtually indicates that the same columns as those illustrated above and below are present.

As described above in the sections <<<Calculation of the first objective variable data>>> and <<<Calculation of the first explanatory variable data>>>, in Fig. 6, when there are a plurality of driving conditions for one rotor fixed attribute, s pieces of the learning motors 200 are used for each of the plural driving conditions. Further, in this case, for s pieces of the learning motors 200, the first objective variable data (motor evaluation index) and the first explanatory variable data 500 are calculated.

This embodiment explains, as an example, the case where one estimation model is calculated using a plurality of pieces of learning data 610a, 610b, 610c, and 610d whose rotor fixed attributes and driving conditions are the same (the part surrounded by a thick line in Fig. 6 is the learning data group). Incidentally, at least one of the rotor fixed attribute and the driving condition may be one.

In Fig. 1, the reference symbol of the learning data acquired by the learning data acquisition part 111 in the manner described above is described as LD. In the following explanation, LD is used as the reference symbol of the learning data acquired by the learning data acquisition part 111 as necessary.

### <<Creation part 112>>

The creation part 112 creates an estimation model that includes the magnetic flux density in the gap as an explanatory variable and includes the motor evaluation index as an objective variable. This embodiment explains, as an example, the case where the creation part 112 creates an estimation model by performing supervised learning that uses the learning data 610a to 610d acquired by the learning data acquisition part 111 as an example of machine learning. Further, this embodiment explains, as an example, the case where an estimation model is created for each rotor fixed attribute and for each driving condition.

The method of creating the estimation model by the creation part 112 is not limited. The creation part 112 only needs to create the estimation model using various machine learning methods, such as, for example, support vector regression, a multiple regression analysis, a neural network, and deep learning. The method of creating the estimation model itself can be achieved by well-known techniques, and thus its detailed explanation is omitted here.

The creation part 112 receives learning condition information LI. The learning condition information LI is information that needs to be set in advance in order to perform learning of the estimation model. In the learning condition information LI, for example, hyperparameters such as a learning rate are included. Incidentally, this embodiment explains, as an example, the case where an operator operates the input device 130 connected to the estimation model creation device 110, to thereby input a numerical value indicating the learning condition information LI to the estimation model creation device 110. In this case, the creation part 112 acquires the numerical value input in this manner as the learning condition information LI. However, as with the driving condition information DI, the motor configuration information MI, the analysis condition information AI, and the simplified stator information SI described above in the sections <<<Calculation of the first objective variable data>>> and <<<Calculation of the first explanatory variable data>>>, the input form of the learning condition information LI is not limited.

### <<Storage part 113>>>

The storage part 113 stores estimation model information EI. The estimation model information EI is information indicating the contents of the estimation model. For example, in the estimation model information EI, of pieces of the information necessary for calculating the objective variable, information other than specific values of the explanatory variable (for example, a relational equation between the explanatory variable and the objective variable) is included.

This embodiment explains, as an example, the case where the estimation model is created for each rotor fixed attribute and for each driving condition. Therefore, it is preferable that the storage part 113 should store information intended for identifying for which rotor fixed attribute and for which driving condition the estimation model information EI indicates an estimation model created (for example, identification information for the rotor fixed attribute and identification information for the driving condition) in association with the estimation model information.

### <<Output part 114>>

The output part 114 outputs the estimation model information EI stored in the storage part 113. The output form of the estimation model information EI is not limited. For example, the output part 114 may transmit the estimation model information EI to the estimation device 120. In this case, the communication between the estimation model creation device 110 and the estimation device 120 may be performed via wireless communication or wired communication. Further, the communication between the estimation model creation device 110 and the estimation device 120 may be performed via a network. Further, the output part 114 may output the estimation model information EI to an external device or a storage medium other than the estimation device 120. In this case, the estimation model information EI is input to the estimation device 120 from the external device or the storage medium. Further, the output part 114 may output the estimation model information EI in response to a request from the estimation device 120, or may output the estimation model information EI spontaneously. When outputting the estimation model information EI spontaneously, for example, the output part 114 may output the estimation model information EI each time the estimation model information EI is newly stored in the storage part 113. Further, it is preferable that the output part 114 should output the information intended for identifying for which rotor fixed attribute and for which driving condition the estimation model information EI indicates an estimation model created (for example, the identification information for the rotor fixed attribute and the identification information for the driving condition).

Next, there is explained in detail an example of the functions of the estimation device 120.

### <Estimation device 120>

### <<Explanatory variable acquisition part 121>>

An explanatory variable acquisition part 121 acquires second explanatory variable data ED. The contents (data items) of the second explanatory variable data ED are the same as those of the first explanatory variable data explained in the section <<Learning data acquisition part 111>>. As illustrated in Fig. 5 as an example, when the first explanatory variable data 500 include the direction components Bᵢᵣ and B_{iθ} of the magnetic flux density vector, the second explanatory variable data ED also include the direction components Bᵢᵣ and B_{iθ} of the magnetic flux density vector. Similarly to the first explanatory variable data 500 described above in the section <<Learning data acquisition part 111>>, the data on magnetic flux density in the gap to be included in the second explanatory variable data ED may be, for example, a measured value. However, it is more efficient to perform a numerical analysis such as the finite element method rather than fabricating various motors and performing measurements.

Thus, this embodiment explains, as an example, the case where the explanatory variable acquisition part 121 acquires the second explanatory variable data ED by calculating them. The method of calculating the second explanatory variable data ED may be, for example, the same method as the method of calculating the first explanatory variable data 500. However, when calculating the second explanatory variable data ED, the explanatory variable acquisition part 121 receives, as the motor configuration information MI, information indicating the configuration of not the learning motor 200 but the estimation motor. The motor configuration information MI of the estimation motor is information indicating the configuration of the estimation motor.

Further, the explanatory variable acquisition part 121 receives simplified stator information SI for the estimation motor. The simplified stator information SI for the estimation motor is information indicating the configuration of the stator of the simplified motor in which the stator of the estimation motor has been simplified. In the information indicating the configuration of the stator of the simplified motor, for example, pieces of information indicating the number, position, size, shape, and material (physical property value) of each of the components of the stator are included. Similarly to the simplified stator information SI for the learning motor 200, the simplified stator information SI for the estimation motor does not also need to be the information on the configuration of the stator itself. For example, in the simplified stator information SI for the estimation motor, information indicating how to modify the stator of the estimation motor may be included.

A specific example of the simplification of the stator of the estimation motor, including modified examples, is the same as that of the simplification of the stator 220 of the learning motor 200 described above in the section <<<Calculation of the first explanatory variable data>>>, and thus its detailed explanation is omitted here. For example, when the estimation motor is the IPMSM 200 illustrated in Fig. 2, the simplified motor in which the stator of the estimation motor has been simplified is the simplified motor 300 illustrated in Fig. 3, for example.

The explanatory variable acquisition part 121 creates shape data of the simplified motor that is a target for performing an electromagnetic field analysis based on the motor configuration information MI of the estimation motor and the simplified stator information SI for the estimation motor.

Further, the explanatory variable acquisition part 121 receives driving condition information DI of the estimation motor. Then, the explanatory variable acquisition part 121 calculates data on magnetic flux density in the gap of the simplified motor in which the stator of the estimation motor has been simplified, for example. For example, when the estimation motor is the IPMSM 200 illustrated in Fig. 2, for example, the direction components Bᵢᵣ and B_{iθ} of the magnetic flux density vector Bᵢ at each position i in the gap center region 410 illustrated in Fig. 4 are calculated. Besides, specific examples of the respective positions of the data on plural magnetic flux densities to be included in the explanatory variable, including modified examples, are the same as those of the respective positions of the data on plural magnetic flux densities to be included in the explanatory variable described above in the section <<<Calculation of the first explanatory variable data>>>, and thus their detailed explanations are omitted here. Further, similarly to the case where the learning data acquisition part 111 calculates the magnetic flux density vector of the simplified motor 300, the explanatory variable acquisition part 121 only needs to perform the calculation of the magnetic flux density vector of the simplified motor at least at one time. This embodiment explains, as an example, the case where the explanatory variable acquisition part 121 performs the calculation of the magnetic flux density vector of the simplified motor at one time, similarly to the learning data acquisition part 111. A specific example of the method of calculating the magnetic flux density vector, including modified examples, is the same as that of the method of calculating the magnetic flux density vector described above in the section <<<Calculation of the first explanatory variable data>>>, and thus its detailed explanation is omitted here.

Incidentally, this embodiment explains, as an example, the case where an operator operates the input device 140 connected to the estimation device 120, to thereby input numerical values indicating the motor configuration information MI, the driving condition information DI, the analysis condition information AI, and the simplified stator information SI to the estimation device 120. In this case, the explanatory variable acquisition part 121 acquires the numerical values input in this manner as the motor configuration information MI, the driving condition information DI, the analysis condition information AI, and the simplified stator information SI. However, the input form of these pieces of information is not limited. For example, the explanatory variable acquisition part 121 may receive these pieces of information from an external device, or may read these pieces of information from a storage medium.

### <<Evaluation index calculation part 122>>

An evaluation index calculation part 122 calculates the motor evaluation index of the estimation motor based on the estimation model created by the estimation model creation device 110 and the second explanatory variable data ED acquired by the explanatory variable acquisition part 121. As described above in the section <<Creation part 112>>>, this embodiment explains, as an example, the case where the estimation model is created for each rotor fixed attribute and for each driving condition. Thus, in this embodiment, for example, the evaluation index calculation part 122 identifies the rotor fixed attributes (for example, the outside diameter, inside diameter, and number of poles of the rotor) based on the motor configuration information MI of the estimation motor, and at the same time, identifies the driving condition of the estimation motor based on the driving condition information DI of the estimation motor. Then, the evaluation index calculation part 122 receives the estimation model information EI of the estimation model corresponding to the identified rotor fixed attributes and driving condition from the estimation model creation device 110 (the output part 114). The evaluation index calculation part 122 calculates the motor evaluation index as the objective variable (second objective variable data) in the estimation model by providing the second explanatory variable data ED to the estimation model. Incidentally, when at least one of a plurality of rotor fixed attributes and a plurality of driving conditions is present, the evaluation index calculation part 122 calculates the motor evaluation index for each of the cases as an example of the estimated value of the evaluation index of the rotary electric machine.

Incidentally, this embodiment explains, as an example, the case where an operator operates the input device 140 connected to the estimation device 120, to thereby input numerical values indicating the motor configuration information MI and the driving condition information DI to the estimation device 120. In this case, the evaluation index calculation part 122 acquires the numerical values input in this manner as the motor configuration information MI and the driving condition information DI. However, the input form of these pieces of information is not limited. For example, the evaluation index calculation part 122 may receive these pieces of information from an external device, or may read these pieces of information from a storage medium.

### <<Output part 123>>

The output part 123 outputs evaluation index information II. The evaluation index information II is information indicating the second objective variable data (motor evaluation index of the estimation motor) calculated by the evaluation index calculation part 122. This embodiment explains, as an example, the case where the output part 123 displays the evaluation index information II on a computer display provided in an output device 150 connected to the estimation device 120. However, the output form of the evaluation index information II is not limited to the display on the computer display. For example, in addition to or instead of the display on the computer display, the output part 123 may perform at least one of the following: transmitting the evaluation index information II to an external device; and storing the evaluation index information II in a storage medium inside or outside the estimation device 120.

### <Flowchart>

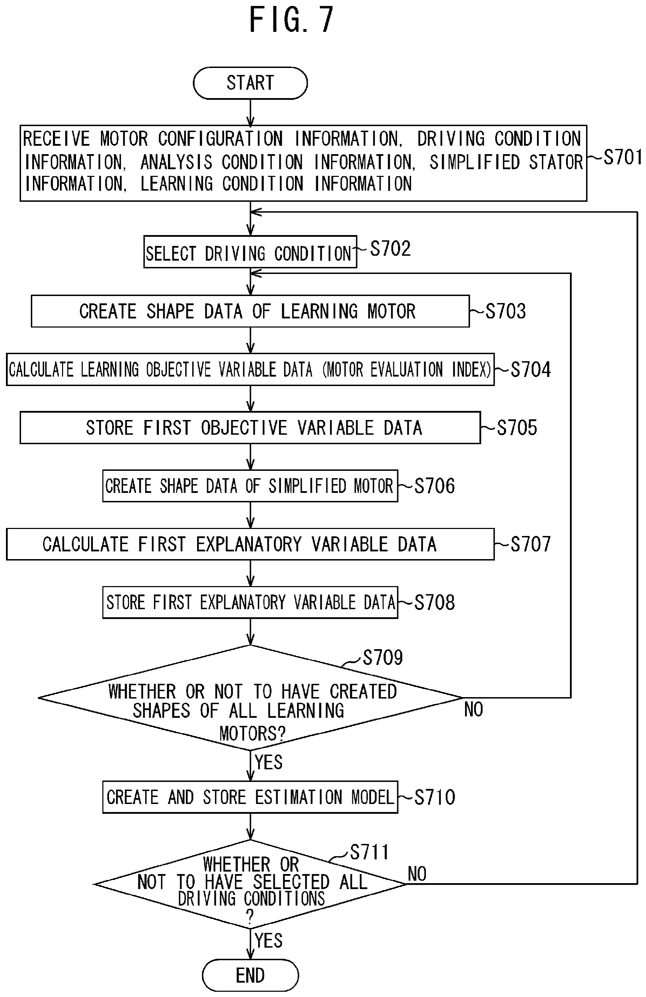

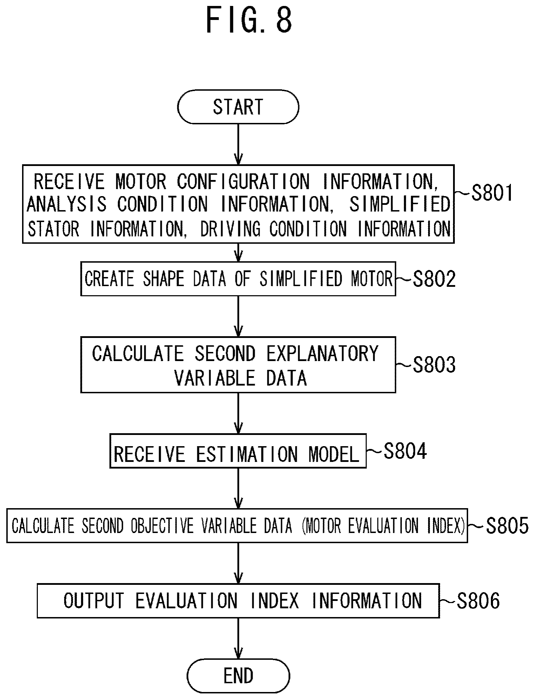

Fig. 7 is a flowchart explaining an example of an estimation model creation method performed by using the estimation model creation device 110. Fig. 8 is a flowchart explaining an example of an estimation method performed by using the estimation device 120. For simplicity of explanation, Fig. 7 and Fig. 8 illustrate, as an example, the case where the number of rotor fixed attributes is one.

### <<Estimation model creation method>>

First, there is explained an example of the estimation model creation method in this embodiment with reference to the flowchart in Fig. 7.

At Step S701, the learning data acquisition part 111 receives the motor configuration information MI of the learning motor 200, the driving condition information DI of the learning motor 200, the analysis condition information AI, and the simplified stator information SI for the learning motor 200. Further, the creation part 112 receives the learning condition information LI. Incidentally, the driving condition information DI only needs to include information indicating one or more driving conditions. Further, the simplified stator information SI may not be present, and in this case, the processing at Step S706 to be described later may be omitted.

Then, at Step S702, the learning data acquisition part 111 selects one driving condition of the learning motor 200 identified by the driving condition information DI of the learning motor 200. Incidentally, when the number of driving conditions of the learning motor 200 identified by the driving condition information DI of the learning motor 200 is one, the processing at Step S702 and the processing at Step S711 to be described later may be omitted.

Then, at Step S703, the learning data acquisition part 111 creates one piece of shape data of the learning motor 200 whose configuration is identified by the motor configuration information MI of the learning motor 200.

Then, at Step S704, the learning data acquisition part 111 calculates the magnetic flux density vector and the eddy current vector in each minute region (mesh) of the learning motor 200 for one cycle when the learning motor 200 is driven (rotated) under the driving condition selected at Step S702. Incidentally, the shape of the learning motor 200 is identified based on the shape data created at Step S703. Then, the learning data acquisition part 111 calculates the motor evaluation index as the first objective variable data based on at least one of the magnetic flux density vector and the eddy current vector calculated in this manner.

Then, at Step S705, the learning data acquisition part 111 stores the motor evaluation index calculated at Step S704 in association with the driving condition used when calculating the motor evaluation index. That is, at Steps S703 to S705, the electromagnetic field analysis is performed on the motor that is not simplified, and thereby the motor evaluation index corresponding to the driving condition selected at Step S702 is calculated.

Then, at Step S706, the learning data acquisition part 111 creates shape data of the simplified motor 300 in which the stator 220 of the learning motor 200 has been simplified based on the simplified stator information SI for the learning motor 200. Incidentally, the learning motor 200 is the learning motor 200 being a target for creating the shape data at Step S703.

Then, at Step S707, the learning data acquisition part 111 calculates the magnetic flux density vector in each minute region (mesh) of the simplified motor 300 at one time. Incidentally, the shape of the simplified motor 300 is identified based on the shape data created at Step S706. Then, the learning data acquisition part 111 calculates the first explanatory variable data 500 (for example, the direction components Bᵢᵣ and B_{iθ} of the magnetic flux density vector at each position i in the gap center region 410) based on the magnetic flux density vector in each minute region (mesh) at one time calculated in this manner. That is, at Steps S706 to S708, the electromagnetic field analysis is performed on the simplified motor 300 in which the stator 220 has been simplified, and thereby the magnetic flux density distribution in the gap is calculated.

Then, at Step S708, the learning data acquisition part 111 stores the first explanatory variable data 500 calculated at Step S707 in association with the first objective variable data (motor evaluation index) stored at Step S705. A set of the first explanatory variable data 500 and the first objective variable data (motor evaluation index) that are associated with each other in this manner is one piece of learning data LD. That is, as described previously, there is a correlation between the magnetic flux density distribution in the gap calculated for the motor in which the stator 220 has been simplified (for example, the simplified motor 300) and the magnetic flux density distribution calculated for the motor in which the stator 220 is not simplified (for example, the learning motor 200). Further, the calculation of the magnetic flux density distribution in the gap of the motor to be evaluated is finished in a shorter time when the calculation is performed for the motor in which the stator has been simplified than when the calculation is performed for the motor in which the stator is not simplified. Therefore, this embodiment explains, as an example, the case of creating learning data by associating the magnetic flux density distribution in the gap calculated for the motor in which the stator has been simplified with the motor evaluation index calculated for the motor in which the stator is not simplified.

Then, at Step S709, it is determined whether or not the learning data acquisition part 111 has created shape data of all of the learning motors 200 whose configurations are identified by the motor configuration information MI of the learning motor 200. As a result of this determination, when the shape data of all of the learning motors 200 have not been created (NO at Step S709), the processing at Step S703 is performed again. Then, at Step S703, one piece of shape data of the learning motor 200, which has not been created, is created, and pieces of the processing at Steps S704 to S708 for the learning motor 200 are performed again.

Then, when it is determined at Step S709 that the shape data of all of the learning motors 200 have been created (YES at Step S709), the processing at Step S710 is performed. At the time the processing at Step S710 is started, s pieces of learning data are created for each driving condition and for each learning motor (see Fig. 6). Incidentally, as described previously, this flowchart explains, as an example, the case where the number of rotor fixed attributes is one, and thus s pieces of learning data are not created for each rotor fixed attribute.

At Step S710, the creation part 112 uses s pieces of the learning data (for example, plural pieces of the learning data 610a illustrated in Fig. 6) whose driving conditions are the same to create an estimation model for the driving condition. Then, the storage part 113 stores the estimation model information EI of the estimation model created by the creation part 112.

Then, at Step S711, it is determined whether or not the estimation model creation device 110 has selected all of the driving conditions identified by the driving condition information DI of the learning motor 200. As a result of this determination, when the estimation model creation device 110 has not selected all of the driving conditions (NO at Step S711), the processing at Step S702 is performed again. Then, at Step S702, the driving condition, which has not been selected, is selected, and pieces of the processing at Steps S703 to S710 for the driving condition are performed again.

Then, when it is determined at Step S711 that all of the driving conditions have been selected, the processing according to the flowchart in Fig. 7 is finished. As a result, the estimation model for each driving condition in one rotor fixed attribute is created. When creating the estimation model for each rotor fixed attribute, for example, pieces of the processing at Steps S702 to S711 may be performed repeatedly for each rotor fixed attribute.

### <<Estimation method>>

Next, there is explained an example of the estimation method in this embodiment with reference to a flowchart in Fig. 8. For simplicity of explanation, Fig. 8 illustrates, as an example, the case where the number of driving conditions of the estimation motor is one.

First, at Step S801, the explanatory variable acquisition part 121 receives the motor configuration information MI of the estimation motor, the analysis condition information AI, and the simplified stator information SI for the estimation motor. Further, the evaluation index calculation part 122 receives the motor configuration information MI of the estimation motor and the driving condition information DI of the estimation motor.

Then, at Step S802, the explanatory variable acquisition part 121 creates shape data of the estimation motor whose configuration is identified by the motor configuration information MI of the estimation motor. Then, based on the simplified stator information SI for the estimation motor, the explanatory variable acquisition part 121 creates shape data of the simplified motor in which the stator of the estimation motor has been simplified.

Then, at Step S803, the explanatory variable acquisition part 121 calculates the magnetic flux density vector in each minute region (mesh) of the simplified motor in which the stator of the estimation motor has been simplified at one time. Incidentally, the shape of the simplified motor is identified based on the shape data created at Step S802. Then, the explanatory variable acquisition part 121 calculates the second explanatory variable data ED (for example, the direction component of the magnetic flux density vector at each position i in the gap center region) based on the magnetic flux density vector in each minute region (mesh) at one time calculated in this manner.

Then, at Step S804, the evaluation index calculation part 122 receives, from the estimation model creation device 110 (the output part 114), the estimation model information EI of the estimation model corresponding to the driving condition identified by the driving condition information DI of the estimation motor. At this time, the evaluation index calculation part 122 may request the estimation model creation device 110 to acquire the estimation model information EI, by including information indicating the driving condition. In this case, the output part 114 of the estimation model creation device 110 may receive the estimation model information EI of the driving condition indicated by the information included in the request from the storage part 113, and output it to the estimation device 120 (the evaluation index calculation part 122). Incidentally, in the flowchart in Fig. 7, when the estimation model is created for each rotor fixed attribute, for example, the evaluation index calculation part 122 only needs to identify the rotor fixed attribute of the estimation motor based on the motor configuration information MI of the estimation motor, and receive the estimation model information EI of the identified rotor fixed attribute from the estimation model creation device 110 (the output part 114).

Then, at Step S805, the evaluation index calculation part 122 provides the second explanatory variable data ED calculated at Step S803 to the estimation model obtained by the estimation model information EI input at Step S804, to thereby calculate the second objective variable data indicating the objective variable in the estimation model (motor evaluation index).

Then, at Step S806, the output part 123 outputs the evaluation index information II indicating the second objective variable data (motor evaluation index) calculated at Step S805. When the processing at Step S806 is finished, the processing according to the flowchart in Fig. 8 is finished.

The flowchart in Fig. 8 may be performed repeatedly, to thereby calculate the second objective variable data (motor evaluation index) for each of the plural estimation motors. In this case, for example, of the motor configuration information MI of the estimation motor, information on at least one of the components (for example, the rotor core and the magnetic poles of the rotor (for example, permanent magnets)) other than the stator 220 may be changed. Specifically, for example, at least one of the number, position, shape, size, and physical property value of the flux barriers formed in the rotor core may be changed. Further, the outside diameter of the rotor may be changed (incidentally, in this case, the size of the gap is also changed). Further, at least one of the number, position, size, and physical property value of the magnetic poles of the rotor may be changed. In the following explanation, at least one of the components other than the stator 220 is referred to as a design target component as necessary.

The design target component may be manufactured based on the second objective variable data (motor evaluation index) in each of the plural estimation motors calculated in the manner described above. Further, a rotary electric machine including the design target component may be manufactured.

For example, the output part 123 of the estimation device 120 may output information indicating the configuration of the design target component included in the motor configuration information MI used when calculating, among pieces of the second objective variable data (motor evaluation indexes) in the respective plural estimation motors, the second objective variable data that satisfy a predetermined condition. The predetermined condition may be, for example, the second objective variable data (motor evaluation index) having a value indicating the highest evaluation. Further, the predetermined condition may also be, for example, u pieces of the second objective variable data (motor evaluation indexes) having the first to uth highest evaluations (u is an integer of 2 or more). In this case, a plurality of sets of information are output as the information indicating the configuration of the design target component.

Further, when the second objective variable data (motor evaluation index) include a plurality of types of objective variables (for example, when including torque and iron loss), the second objective variable data (motor evaluation index) having a value indicating the highest evaluation may be selected by comprehensively considering the values of plural types of objective variables. In this case, the predetermined condition may also be, for example, the second objective variable data (motor evaluation index) with the largest or smallest weighted average value of the values of plural types of objective variables. Incidentally, the weighted average is also referred to as a weighted mean.

Further, when the second objective variable data (motor evaluation index) include a plurality of types of objective variables (for example, when including torque and iron loss), the second objective variable data (motor evaluation index) having a value indicating the highest evaluation may be selected for each type of objective variable. In this case, a plurality of sets of information are output as the information indicating the configuration of the design target component.

Then, the design target component may be manufactured based on the information on the design target component output by the output part 123.

When the number of sets of the information on the design target component output by the output part 123 is one, the design target component having a configuration indicated by the information on the design target component may be manufactured.

When the number of sets of the information on the design target component output by the output part 123 is plural, the design target component having a configuration indicated by one set of information among the plural sets of information may be manufactured. For example, an operator (for example, a designer) may select one set of information from the plural sets of information by comprehensively considering a degree of evaluation based on the second objective variable data (motor evaluation index), ease of manufacture, and low manufacturing cost. Incidentally, this selection may be performed by the estimation device 120, for example. In this case, for example, the estimation device 120 may perform calculation of index values obtained by quantifying the degree of evaluation based on the second objective variable data (motor evaluation index), the ease of manufacture, and the low manufacturing cost, calculation of a weighted average value of the index values, and section of one set of information from the plural sets of information based on the weighted average value.

Then, the design target component having a configuration indicated by the information on the design target component selected in the manner described above may be manufactured.

Further, modifications may be added to the configuration indicated by the information on the design target component from the viewpoint of ease of manufacture, or the like.

Then, a rotary electric machine including the design target component manufactured in the manner described above may be manufactured.

Incidentally, the methods of manufacturing the design target component and the rotary electric machine themselves can be achieved by well-known techniques, and thus their detailed explanations are omitted here.

As described previously, the rotary electric machine to which this embodiment is to be applied is not limited. However, it is preferable that the rotary electric machine to which this embodiment is to be applied should be a rotary electric machine that includes a rotor including permanent magnets. For example, when at least one of the rotor core and the magnetic poles of the rotor is included in the design target component, if the magnetic poles of the rotor are determined by the permanent magnets, various patterns can be easily created as modification patterns for the configuration of the design target component.

### <Hardware>

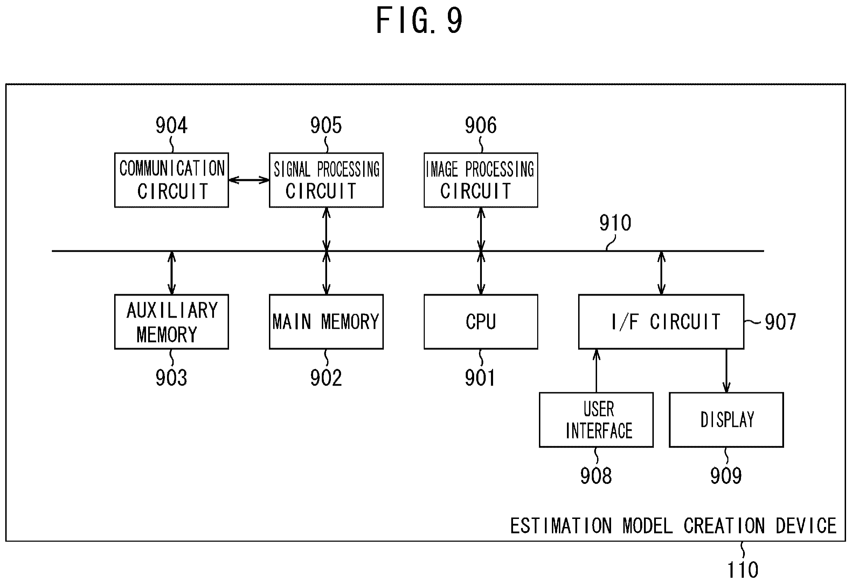

Next, there is explained one example of the hardware of the estimation model creation device 110. In Fig. 9, the estimation model creation device 110 includes a CPU 901, a main memory 902, an auxiliary memory 903, a communication circuit 904, a signal processing circuit 905, an image processing circuit 906, an I/F circuit 907, a user interface 908, a display 909, and a bus 910.

The CPU 901 overall controls the entire estimation model creation device 110. The CPU 901 uses the main memory 902 as a work area to execute a program stored in the auxiliary memory 903. The main memory 902 stores data temporarily. The auxiliary memory 903 stores various data, in addition to programs to be executed by the CPU 901.

The communication circuit 904 is a circuit intended for performing communication with the outside of the estimation model creation device 110. The communication circuit 904 may perform wireless communication or wired communication with the outside of the estimation model creation device 110.

The signal processing circuit 905 performs various pieces of signal processing on signals received in the communication circuit 904 and signals input according to the control by the CPU 901.

The image processing circuit 906 performs various pieces of image processing on signals input according to the control by the CPU 901. The signal that has been subjected to the image processing is output on the display 909, for example.

The user interface 908 is a part in which an operator gives an instruction to the estimation model creation device 110. The user interface 908 includes buttons, switches, dials, and so on, for example. Further, the user interface 908 may include a graphical user interface using the display 909.

The display 909 displays an image based on a signal output from the image processing circuit 906. The I/F circuit 907 exchanges data with a device connected to the I/F circuit 907. In Fig. 9, as the device to be connected to the I/F circuit 907, the user interface 908 and the display 909 are illustrated. However, the device to be connected to the I/F circuit 907 is not limited to these. For example, a portable storage medium may be connected to the I/F circuit 907. Further, at least a part of the user interface 908 and the display 909 may be provided outside the estimation model creation device 110.

Incidentally, the CPU 901, the main memory 902, the auxiliary memory 903, the signal processing circuit 905, the image processing circuit 906, and the I/F circuit 907 are connected to the bus 910. Communication among these components is performed via the bus 910. Further, the hardware of the estimation model creation device 110 is not limited to the hardware illustrated in Fig. 9 as long as it can perform the previously-described functions of the estimation model creation device 110. For example, a GPU may be used as a processor instead of or in addition to the CPU 901. Further, the hardware of the estimation device 120 is also performed by the same hardware as the hardware of the estimation model creation device 110 illustrated in Fig. 9, for example. Therefore, a detailed explanation of a specific example of the hardware of the estimation device 120 is omitted here.

### <Calculation example>

Next, there is explained a calculation example using the methods explained in this embodiment. Table 1 illustrates analysis conditions in this calculation example.

**[Table 1]**

| MOTOR MODEL | V-SHAPED IPMSM MODEL |
|---|---|
| NUMBER OF POLES | EIGHT POLES |
| CURRENT AMPLITUDE | 20Apeak |
| CURRENT LEAD ANGLE | 40° |
| ROTATION SPEED | 1000rpm |
| NUMBER OF SUPERVISED DATA | 300 |
| NUMBER OF TEST DATA | 700 |
| OBJECTIVE VARIABLE | AVERAGE TORQUE |
| EXPLANATORY VARIABLE | PHASES·AMPLITUDES OF 0TH TO 13TH ORDER SPACIAL HARMONICS OF RADIAL·CIRCUMFERENTIAL DIRECTION COMPONENTS OF MAGNETIC FLUX DENSITY |
| ESTIMATION MODEL | SUPPORT VECTOR REGRESSION |
| *γ* VALUE | 1.0 × 10⁻⁵ |
| C VALUE | 1.0 |
| *ε* VALUE | 1.0 × 10⁻³ |

As illustrated in Table 1, in this calculation example, a V-shaped IPMSM with 8 poles (the IPMSM200 illustrated in Fig. 2) was used as the estimation motor. Table 1 illustrates calculation results when the V-shaped IPMSM was driven under the following driving conditions: current amplitude of 20 A, current lead angle of 40°, and rotation speed of 1000 rpm.

Further, as illustrated in Table 1, in this calculation example, a support vector regression model, which is one of the machine learning models, was used as the estimation model. The torque of the V-shaped IPMSM was used as the objective variable of the support vector regression model. Further, as the explanatory variable of the support vector regression model, phases and amplitudes of the 0th to 13th order spatial harmonics of the r-direction component (radial direction component) of the magnetic flux density vector, and phases and amplitudes of the 0th to 13th order spatial harmonics of the θ-direction component (circumferential direction component) of the magnetic flux density vector were used. In Table 1, these phases and amplitudes of the 0th to 13th order spatial harmonics are described as phases and amplitudes of spatial harmonics. Further, in the explanation of this calculation example, these phases and amplitudes of the 0th to 13th order spatial harmonics are abbreviated to phases and amplitudes of spatial harmonics as necessary.

For the V-shaped IPMSM (the IPMSM 200 illustrated in Fig. 2), 300 V-shaped IPMSMs including the rotors 210 whose configurations are different from one another were used as the learning motor. For each of these 300 learning motors, the first explanatory variable data and the first objective variable data (correct answer labels) were calculated as explained in this embodiment, and 300 sets of learning data groups were created.

When calculating the learning data (the first explanatory variable data), the stator was simplified so that it was formed only of a hollow cylindrical shaped stator core where no stator coils or teeth (slots) are present, as illustrated in Fig. 3. Then, the support vector regression model was created by performing supervised learning using these 300 pieces of learning data. The values illustrated in Table 1 were used as the y value, C value, and ε value, which are hyperparameters of the support vector regression model.

Further, similarly to the learning data, 700 pieces of test data were calculated in the manner explained in this embodiment.

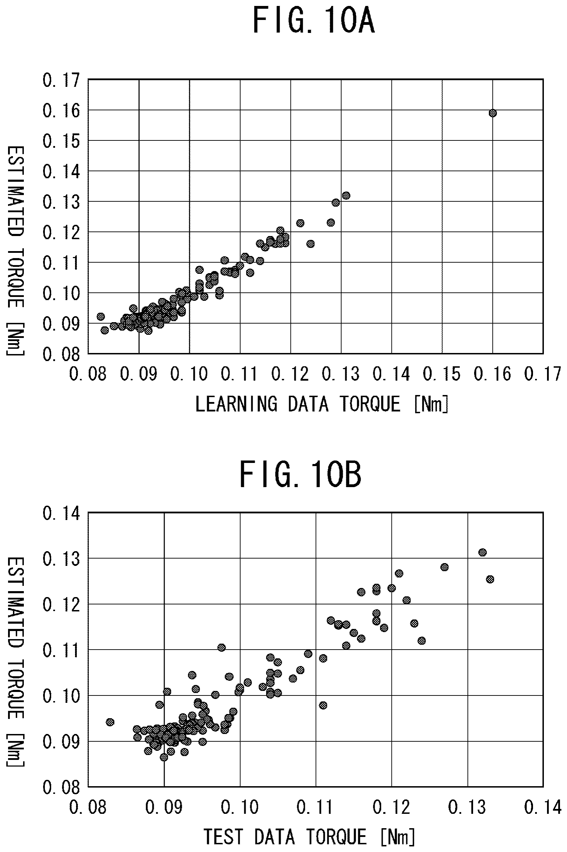

Fig. 10A and Fig. 10B are views each illustrating analysis results in this calculation example. The learning data torque illustrated in Fig. 10A is an average torque (correct answer label) included in 300 pieces of the learning data described previously. The estimated torque illustrated in Fig. 10A is an average torque calculated by providing the first explanatory variable data included in the learning data to the support vector regression model. The test data torque illustrated in Fig. 10B is an average torque (correct answer label) included in 700 pieces of the test data described previously. The estimated torque illustrated in Fig. 10B is an average torque calculated by providing the explanatory variable data included in the test data to the support vector regression model.

In the results illustrated in Fig. 10A, a coefficient of determination R₂ was 0.953. In the results illustrated in Fig. 10B, the coefficient of determination R₂ was 0.847. It can be seen that using the methods explained as above in this embodiment makes it possible to estimate the motor evaluation index with high accuracy even with a small number of learning data.

### <Summary>

As above, in this embodiment, the estimation model creation device 110 acquires the magnetic flux density distribution in the gap G between the rotor 210 and the stator 320. The estimation model creation device 110 calculates the estimated value of the motor evaluation index corresponding to the acquired magnetic flux density distribution using the estimation model created by learning the relationship between the magnetic flux density distribution in the gap G and the motor evaluation index. Therefore, the dimension of the explanatory variable (amount of information) can be reduced. This makes it possible to prevent the number of learning data from increasing too large. As a result, the calculation load when learning the estimation model can be reduced.

Further, in this embodiment, the magnetic flux density distribution consisting of magnetic flux densities to be included in the explanatory variable of the estimation model is a set of magnetic flux densities at each of a plurality of positions along the circumferential direction of the rotor 210. These magnetic flux densities are preferably magnetic flux densities at the same time. Further, each of these magnetic flux densities is the magnetic flux density at a specified position in the radial direction of the gap G between the rotor 210 and the stator 320 (radial direction of the rotary electric machine). It is preferable that the specified position should be a position where the distance from the rotation axis line 0 in the radial direction is constant (see the radius vector r_{gc} in Fig. 4). Therefore, as the data on explanatory variable, data on explanatory variable that appropriately reflect the motor evaluation index can be used. This embodiment has explained, as an example, the case where such plural positions are the gap center region 410. Such plural positions do not necessarily need to be the center positions in the radial direction of the gap G, but they are preferably values at specified positions in the radial direction of the gap G. Otherwise, the position of the magnetic flux density in the radial direction may change depending on the position in the circumferential direction. For example, at one position in the circumferential direction, the position of the magnetic flux density in the radial direction is near the rotor 210, whereas at another position in the circumferential direction, the position of the magnetic flux density in the radial direction is near the stator 320. If such data on magnetic flux density are used as the data on explanatory variable, information on specific positions that have little relevance to the motor evaluation index is likely to be included in the data on explanatory variable. Therefore, the estimation accuracy of the motor evaluation index may decrease.

Further, in this embodiment, the estimation model is set as a learned model created by supervised learning. Therefore, the estimation model that satisfies the estimation accuracy can be created easily.

Further, in this embodiment, the estimation model creation device 110 performs supervised learning using the learning data in which the magnetic flux density distribution in the gap G in the simplified motor 300 and the motor evaluation index are associated. The simplified motor 300 is a motor in which the stator 220 has been simplified compared to the IPMSM 200 (learning motor, estimation motor). The target for simplification is, for example, at least one of the stator coil and the teeth of the stator core. Therefore, it is possible to simplify the configuration of the motor to be used for acquiring the data on explanatory variable (the first explanatory variable data and the second explanatory variable data). Thus, the acquisition of the data on explanatory variable is facilitated.

Further, in this embodiment, the estimation model creation device 110 and the estimation device 120 calculate the magnetic flux density distribution in the gap G between the rotor 210 and the stator 320 by performing an electromagnetic field analysis on the simplified motor 300. In this case, the estimation model creation device 110 and the estimation device 120 perform an analysis at one time or an analysis at a plurality of times within a period of less than one cycle as the electromagnetic field analysis. Therefore, the data on explanatory variable (the first explanatory variable data and the second explanatory variable data) can be acquired at a higher speed.

Further, in this embodiment, the estimation model creation device 110 and the estimation device 120 calculate the magnetic flux density distribution in the gap G between the rotor 210 and the stator 320 by performing an electromagnetic field analysis. Therefore, it is possible to achieve the improvement in the accuracy of the data on explanatory variable (the first explanatory variable data and the second explanatory variable data) and the acquisition of the data on explanatory variable at high speed.

Further, in this embodiment, data on each of the plural magnetic flux densities that constitute the magnetic flux density distribution to be included in the explanatory variable are composed of the component values of the magnetic flux density vector. Therefore, data that are more accurately reflected in the motor evaluation index can be used as the data on magnetic flux density.

The estimation model creation device 110 calculates the motor evaluation index to be included in the learning data (the first objective variable data) by performing an electromagnetic field analysis on the learning motor 200 including the stator 220 before simplification. Therefore, it is therefore possible to achieve the improvement in the accuracy of the learning data (the first objective variable data) and the acquisition of the learning data (the first objective variable data) at high speed.

### (Other modified examples)

Incidentally, the embodiment of the present invention explained above can be implemented by causing a computer to execute a program. Further, a computer-readable recording medium in which the aforementioned program is recorded and a computer program product such as the aforementioned program can also be applied as the embodiment of the present invention. As the recording medium, it is possible to use a flexible disk, a hard disk, an optical disk, a magneto-optic disk, a CD-ROM, a magnetic tape, a nonvolatile memory card, a ROM, or the like, for example.

Further, the embodiments of the present invention explained above merely illustrate concrete examples of implementing the present invention, and the technical scope of the present invention is not to be construed in a restrictive manner by the embodiment. That is, the present invention may be implemented in various forms without departing from the technical spirit or main features thereof.

### INDUSTRIAL APPLICABILITY

The present invention can be utilized for evaluating the performance of a rotary electric machine, for example.

## Claims

1. An estimation device for estimating an evaluation index of a rotary electric machine including a rotor and a stator, the estimation device comprising:
an explanatory variable acquisition part configured to acquire a magnetic flux density distribution in a gap between the rotor and the stator; and
an evaluation index calculation part configured to calculate an estimated value of the evaluation index corresponding to the magnetic flux density distribution by using an estimation model created by learning a relationship between the magnetic flux density distribution in the gap and the evaluation index.

2. The estimation device according to claim 1,
wherein the magnetic flux density distribution is a set of magnetic flux densities at each of a plurality of positions along a circumferential direction of the rotor, and
wherein each of the magnetic flux densities is a magnetic flux density at a specified position in a radial direction of the gap.

3. The estimation device according to claim 1 or 2,
wherein the estimation model is a learned model created by performing machine learning using learning data, and
wherein the learning data are data in which the magnetic flux density distribution and an actual value of the evaluation index are mutually associated.

4. The estimation device according to claim 3,
wherein the estimation model is a learned model created by performing machine learning using learning data,
wherein the learning data are data in which the magnetic flux density distribution in a simplified rotary electric machine and an actual value of the evaluation index are mutually associated,
wherein the simplified rotary electric machine is a rotary electric machine in which a stator of a rotary electric machine being a target for calculating the evaluation index has been simplified,
wherein the actual value of the evaluation index is an actual value in the rotary electric machine being a target for calculating the evaluation index, and
wherein the explanatory variable acquisition part acquires the magnetic flux density distribution in the simplified rotary electric machine.

5. The estimation device according to claim 4,
wherein a target for the simplification is at least one of a stator coil and teeth of a stator core.

6. The estimation device according to claim 4 or 5,
wherein the explanatory variable acquisition part calculates the magnetic flux density distribution by performing an electromagnetic field analysis on the simplified rotary electric machine, and
wherein the electromagnetic field analysis is an analysis at one time, or an analysis at a plurality of times within a period of less than one cycle.

7. The estimation device according to any one of claims 1 to 6,
wherein the explanatory variable acquisition part calculates the magnetic flux density distribution by performing an electromagnetic field analysis.

8. The estimation device according to any one of claims 1 to 7,
wherein data on each of a plurality of magnetic flux densities constituting the magnetic flux density distribution are composed of component values of a magnetic flux density vector.

9. An estimation model creation device for creating an estimation model intended for estimating an evaluation index of a rotary electric machine including a rotor and a stator, the estimation model creation device comprising:
a creation part configured to create the estimation model by learning a relationship between a magnetic flux density distribution in a gap between the rotor and the stator and the evaluation index.

10. The estimation model creation device according to claim 9,
wherein the magnetic flux density distribution is a set of magnetic flux densities at each of a plurality of positions along a circumferential direction of the rotor, and
wherein each of the magnetic flux densities is a magnetic flux density at a specified position in a radial direction of the gap.

11. The estimation model creation device according to claim 9 or 10, further comprising:
a learning data acquisition part configured to acquire learning data in which the magnetic flux density distribution and an actual value of the evaluation index are associated,
wherein the creation part creates the estimation model by performing machine learning using the learning data.

12. The estimation model creation device according to claim 11,
wherein the learning data acquisition part acquires learning data in which the magnetic flux density distribution in a simplified rotary electric machine and an actual value of the evaluation index are associated,
wherein the simplified rotary electric machine is a rotary electric machine in which a stator of a rotary electric machine being a target for calculating the evaluation index has been simplified, and
wherein the actual value of the evaluation index is an actual value in the rotary electric machine being a target for calculating the evaluation index.

13. The estimation model creation device according to claim 12,
wherein a target for the simplification is at least one of a stator coil and teeth of a stator core.

14. The estimation model creation device according to claim 12 or 13,
wherein the learning data acquisition part calculates the actual value of the evaluation index by performing an electromagnetic field analysis on a rotary electric machine including a stator before the simplification.

15. The estimation model creation device according to any one of claims 12 to 14,
wherein the learning data acquisition part calculates the magnetic flux density distribution by performing an electromagnetic field analysis on the simplified rotary electric machine, and
wherein the electromagnetic field analysis is an analysis at one time, or an analysis at a plurality of times within a period of less than one cycle.

16. The estimation model creation device according to any one of claims 11 to 15,
wherein the learning data acquisition part calculates the magnetic flux density distribution by performing an electromagnetic field analysis.

17. The estimation model creation device according to any one of claims 9 to 16,
wherein data on a plurality of magnetic flux densities constituting the magnetic flux density distribution are composed of component values of a magnetic flux density vector.

18. An estimation method of estimating an evaluation index of a rotary electric machine including a rotor and a stator, the estimation method comprising:
an explanatory variable acquisition step of acquiring a magnetic flux density distribution in a gap between the rotor and the stator; and
an evaluation index calculation step of calculating an estimated value of the evaluation index corresponding to the magnetic flux density distribution by using an estimation model created by learning a relationship between the magnetic flux density distribution in the gap and the evaluation index.

19. An estimation model creation method of creating an estimation model intended for estimating an evaluation index of a rotary electric machine including a rotor and a stator, the estimation model creation method comprising:
a creation step of creating the estimation model by learning a relationship between a magnetic flux density distribution in a gap between the rotor and the stator and the evaluation index.

20. A program for causing a computer to function as each part of the estimation device according to any one of claims 1 to 8.

21. A program for causing a computer to function as each part of the estimation model creation device according to any one of claims 9 to 17.
